# EUROPEAN PATENT APPLICATION

(11) **EP 4 730 554 A1**
(43) Date of publication of application: **22.04.2026**
(21) Application number: 24843307.0
(22) Date of filing: 05.06.2024
(51) Int. Cl.: H01Q 1/24, H01Q 1/38, H01Q 21/06, H05K 9/00, H05K 1/02

(54) **ANTENNA STRUCTURE AND ELECTRONIC DEVICE COMPRISING SAME**

(30) Priority: 19.07.2023 KR 20230094068; 13.09.2023 KR 20230121873
(71) Applicant: Samsung Electronics Co., Ltd., Suwon-si, Gyeonggi-do 16677 (KR)
(72) Inventor: HWANG, Jihye, Suwon-si Gyeonggi-do 16677 (KR); KANG, Hyeonuk, Suwon-si Gyeonggi-do 16677 (KR); KIM, Soojung, Suwon-si Gyeonggi-do 16677 (KR); HAN, Yunjae, Suwon-si Gyeonggi-do 16677 (KR); LEE, Kyungjae, Suwon-si Gyeonggi-do 16677 (KR)
(74) Representative: Nederlandsch Octrooibureau
(86) International application number: PCT/KR2024/007690
(87) International publication number: WO 2025/018586

(57) **Abstract**

According to an embodiment of the present disclosure, an electronic device may comprise a housing, a circuit board, an antenna module, or a conductive support member. The housing may include a ground area. The antenna module may be disposed in the housing. The antenna module may be electrically connected to the circuit board. The antenna module may include a substrate or an antenna array. The antenna array may be disposed on the substrate. The conductive support member may be configured to support the antenna module. The conductive support member may include a bracket or a contact portion. The bracket may surround at least a part of the substrate. The contact portion may protrude from the bracket. The contact portion may be electrically connected to the ground area. Various other embodiments may also be possible.

## Description

### [Technical Field]

Various embodiments of the disclosure relate to an electronic device, e.g., an antenna structure and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

The above-described information may be provided as related art for the purpose of helping understanding of the disclosure. No claim or determination is made as to whether any of the foregoing is applicable as background art in relation to the disclosure.

### [Detailed Description of the Invention]

### [Technical Solution]

According to an embodiment of the disclosure, an electronic device may include a housing, a circuit board, an antenna module, or a conductive support member. The housing may include a ground area. The circuit board may be disposed inside the housing. The antenna module may be disposed in the housing. The antenna module may be disposed in the housing. The antenna module may be electrically connected to the circuit board. The antenna module may include a substrate, or an antenna array. The antenna array may be disposed on the substrate. The conductive support member may be configured to support the antenna module. The conductive support member may include a bracket, or a contacting portion. The bracket may surround at least a portion of the substrate. The contacting portion may protrude from the bracket. The contacting portion may contact the ground area. The contacting portion may be electrically connected to the ground area.

According to an embodiment of the disclosure, an electronic device may include a housing, a circuit board, an antenna module, a conductive support member, or a shielding member. The housing may include a ground area. The circuit board may be disposed inside the housing. The antenna module may be disposed in the housing. The antenna module may be disposed in the housing. The antenna module may be electrically connected to the circuit board. The antenna module may include a substrate, or an antenna array. The antenna array may be disposed on the substrate. The conductive support member may be configured to support the antenna module. The conductive support member may include a bracket, or a contacting portion. The bracket may surround at least a portion of the substrate. The contacting portion may protrude from the bracket. The contacting portion may contact the ground area. The contacting portion may be electrically connected to the ground area. The shielding member may be disposed between the bracket and the substrate. The shielding member may be electrically connected to the bracket, or the substrate.

### [Brief Description of Drawings]

FIG. 1 is a block diagram illustrating an electronic device in a network environment according to an embodiment.
FIG. 2 is a front perspective view illustrating an electronic device according to an embodiment of the disclosure.
FIG. 3 is a rear perspective view illustrating an electronic device according to an embodiment of the disclosure.
FIG. 4 is a front exploded perspective view illustrating an electronic device according to an embodiment of the disclosure.
FIG. 5 is a rear exploded perspective view illustrating an electronic device according to an embodiment of the disclosure.
FIG. 6 is a front view illustrating an electronic device including an antenna module according to an embodiment of the disclosure.
FIG. 7 is an enlarged view illustrating portion "A" of FIG. 6 according to an embodiment of the disclosure.
FIG. 8 is a perspective view illustrating an electronic device including an antenna module according to an embodiment of the disclosure.
FIG. 9 is a perspective view illustrating an antenna module and a conductive support member according to an embodiment of the disclosure.
FIG. 10 is a perspective view illustrating an antenna module according to an embodiment of the disclosure.
FIG. 11 is a perspective view illustrating an antenna module according to an embodiment of the disclosure.
FIG. 12 is a perspective view illustrating a conductive support member according to an embodiment of the disclosure.
FIG. 13 is a cross-sectional view illustrating an electronic device taken along line B-B' of FIG. 7 according to an embodiment of the disclosure.
FIG. 14 is a cross-sectional view illustrating an electronic device taken along line B-B' of FIG. 7 according to an embodiment of the disclosure.
FIG. 15 is a cross-sectional view illustrating an electronic device according to an embodiment of the disclosure.
FIG. 16A is a plan view illustrating a 2-1th support portion of a conductive support member according to an embodiment of the disclosure.
FIG. 16B is a cross-sectional view taken along line C-C' of FIG. 16A according to an embodiment of the disclosure.
FIG. 17A is a plan view illustrating a 2-1th support portion of a conductive support member according to an embodiment of the disclosure.
FIG. 17B is a cross-sectional view taken along line D-D' of FIG. 17A according to an embodiment of the disclosure.
FIG. 18A is a plan view illustrating a 2-1th support portion and a contacting portion of a support member according to an embodiment of the disclosure.
FIG. 18B is a cross-sectional view taken along line E-E' of FIG. 18A according to an embodiment of the disclosure.
FIG. 19 is a rear view illustrating an electronic device including an antenna module according to an embodiment of the disclosure.
FIG. 20 is a cross-sectional view illustrating an electronic device taken along line F-F' of FIG. 19 according to an embodiment of the disclosure.
FIG. 21 is a perspective view illustrating a conductive support member according to an embodiment of the disclosure.
FIG. 22 is a perspective view illustrating a conductive support member according to an embodiment of the disclosure.
FIG. 23 is a cross-sectional view illustrating an electronic device according to an embodiment of the disclosure.
FIG. 24 is a perspective view illustrating an antenna module and a conductive support member according to an embodiment of the disclosure.
FIG. 25 is a perspective view illustrating an antenna module and a conductive support member according to an embodiment of the disclosure.
FIG. 26 is a perspective view illustrating an antenna module and a conductive support member according to an embodiment of the disclosure.
FIG. 27 is a perspective view illustrating an antenna module and a conductive support member according to an embodiment of the disclosure.

### [Mode for Carrying out the Invention]

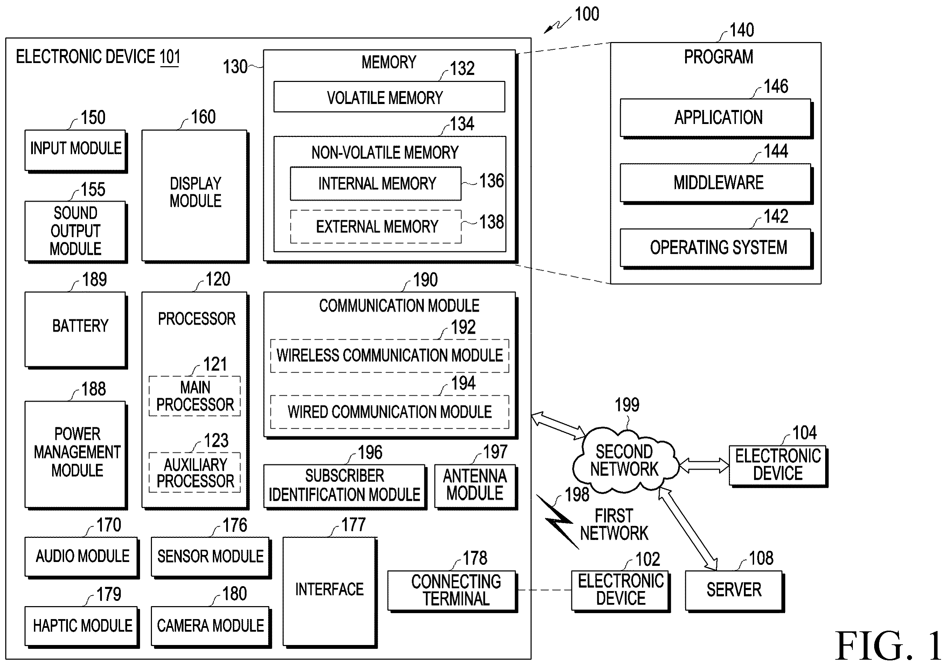

FIG. 1 is a block diagram illustrating an electronic device 101 in a network environment 100, according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wiredly) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

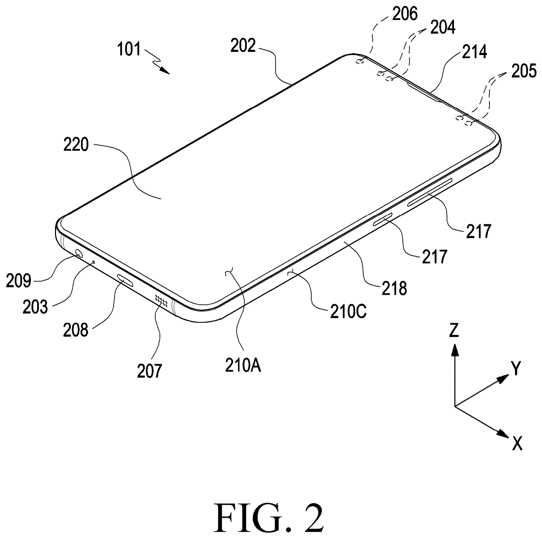

FIG. 2 is a front perspective view illustrating an electronic device according to an embodiment of the disclosure.

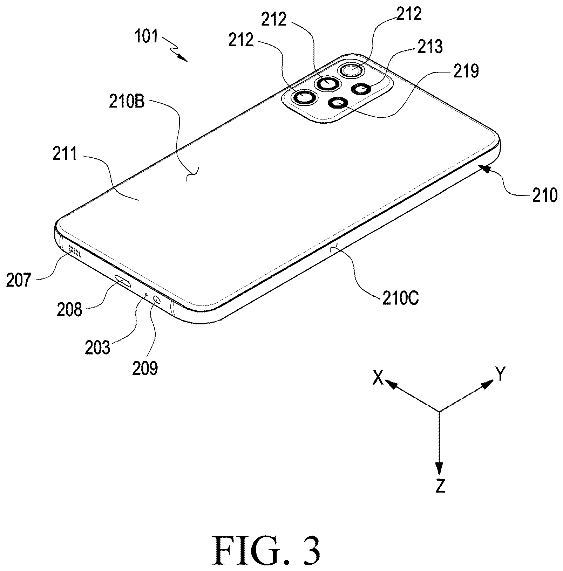

FIG. 3 is a rear perspective view illustrating an electronic device according to an embodiment of the disclosure.

Hereinafter, for convenience of description of FIGS. 2 to 27, FIGS. 2 to 27 illustrate a Cartesian coordinate system defined and/or interpreted with the X, Y and Z axes orthogonal to each other. Hereinafter, for convenience of description, the X-axis direction may be defined and interpreted as the width direction of the electronic device or components, the Y-axis direction may be defined and interpreted as the length direction of the electronic device or components, and the Z-axis direction may be defined and interpreted as the height direction (or thickness direction) of the electronic device or components.

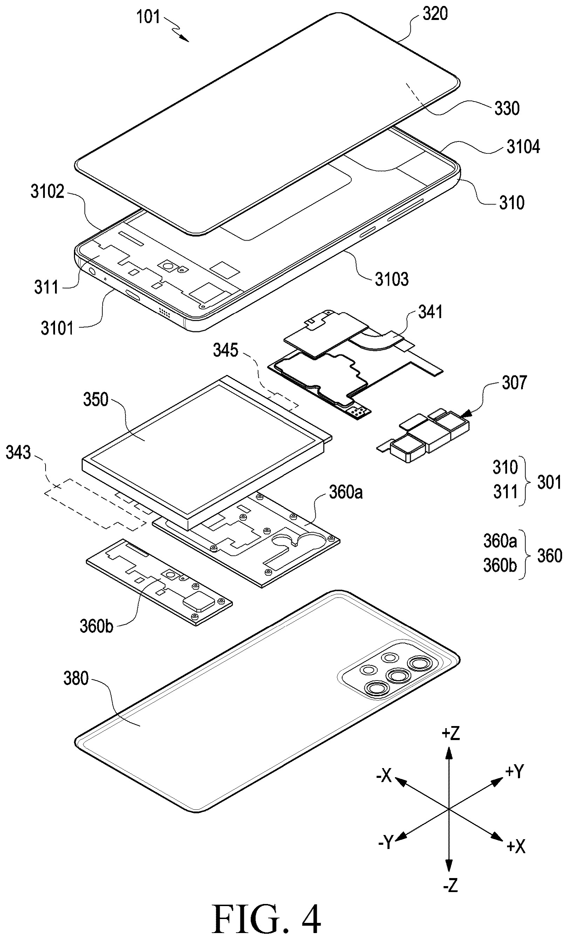

The embodiments of FIGS. 2 and 3 may be combined with the embodiment of FIG. 1 or the embodiments of FIGS. 4 to 27.

Referring to FIGS. 2 and 3, according to an embodiment, an electronic device 101 (e.g., the electronic device 101 of FIG. 1) may include a housing 210 including a first surface (or front surface) 210A, a second surface (or rear surface) 210B, and a side surface 210C surrounding a space between the first surface 210A and the second surface 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or the rear plate 211 may have a substantially flat plate shape. For example, no bent and extended area may be included. When an area bending and extending is included, the thickness of the electronic device 101 at the portion including the area bending and extending may be smaller than the thickness of the rest.

According to an embodiment, the electronic device 101 may include at least one or more of a display 220, audio modules 203, 207, and 214, sensor modules 204 and 219, camera modules 205, 212, and 213, key input devices 217, a light emitting device 206, and connector holes 208 and 209. In an embodiment, the electronic device 101 may exclude at least one (e.g., the key input device 217 or the light emitting device 206) of the components or may add other components.

The display 220 may be visually exposed through a significant portion of the front plate 202. In an embodiment, at least a portion of the display 220 may be visually exposed through the front plate 202 forming the first surface 210A, or through a portion of the side surface 210C. In an embodiment, the edge of the display 220 may be formed to be substantially the same in shape as an adjacent outer edge of the front plate 202. In an embodiment (not illustrated), the interval between the outer edge of the display 220 and the outer edge of the front plate 202 may remain substantially even to give a larger area of visual exposure of the display 220.

In an embodiment (not shown), the screen display region of the display 220 may have a recess or opening in a portion thereof, and at least one or more of the audio module 214, sensor module 204, camera module 205, and light emitting device 206 may be aligned with the recess or opening. In an embodiment (not shown), at least one or more of the audio module 214, sensor module 204, camera module 205, fingerprint sensor (not shown), and light emitting device 206 may be included on the rear surface of the screen display area of the display 220. In an embodiment (not illustrated), the display 220 may be disposed to be coupled with, or adjacent, a touch detecting circuit, a pressure sensor capable of measuring the strength (pressure) of touches, and/or a digitizer for detecting a magnetic field-type stylus pen.

The audio modules 203, 207, and 214 may include a microphone hole 203 and speaker holes 207 and 214. A microphone for acquiring external sounds may be disposed in the microphone hole 203. In an embodiment, a plurality of microphones may be disposed to detect the direction of the sound. The speaker holes 207 and 214 may include an external speaker hole 207 and a phone receiver hole 214. In an embodiment, the speaker holes 207 and 214 and the microphone hole 203 may be implemented as a single hole, or speakers may be rested without the speaker holes 207 and 214 (e.g., piezo speakers).

The sensor modules 204 and 219 may generate an electrical signal or data value corresponding to an internal operating state or external environmental state of the electronic device 101. For example, the sensor modules 204 and 219 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 220) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, two or more lenses (infrared cameras, wide-angle and telephoto lenses) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 220. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., a light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector 472 hole 209 (e.g., an earphone jack) for receiving a connector for transmitting or receiving audio signals to/from the external electronic device.

FIG. 4 is a front exploded perspective view illustrating an electronic device according to an embodiment of the disclosure.

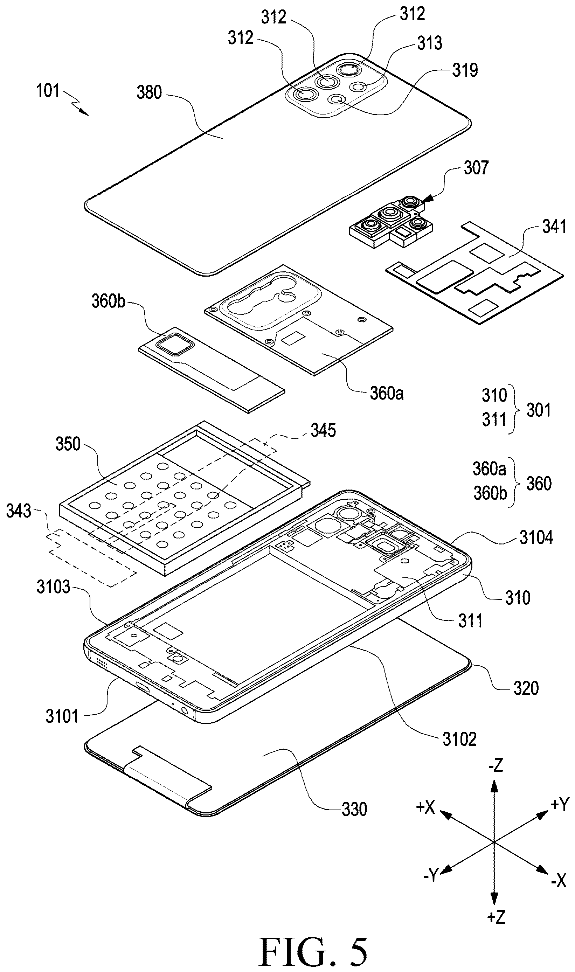

FIG. 5 is a rear exploded perspective view illustrating an electronic device according to an embodiment of the disclosure.

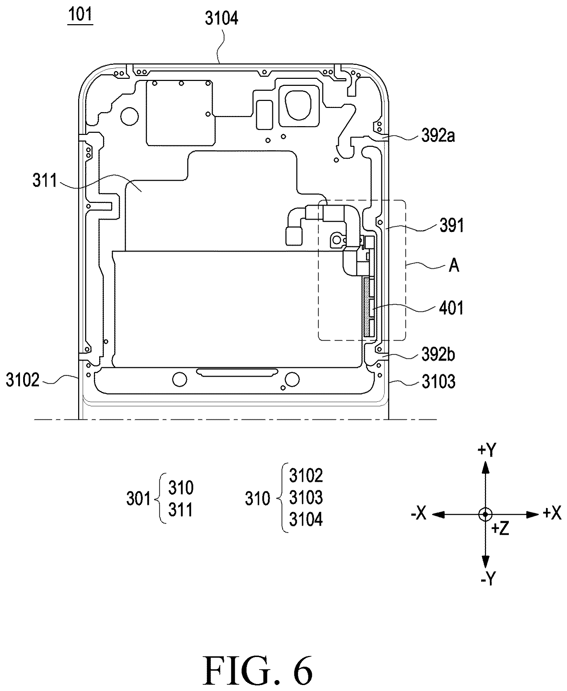

The embodiments of FIGS. 4 and 5 may be combined with the embodiments of FIGS. 1 to 3 or the embodiments of FIGS. 6 to 27.

Referring to FIGS. 3 and 4, an electronic device 101 (e.g., the electronic device 101 of FIG. 1 or FIG. 2) may include a side structure 310, a first support member 311 (e.g., a bracket), a front plate 320 (e.g., the front plate 202 of FIG. 1), a display 330 (e.g., the display 220 of FIG. 1), at least one printed circuit board (or a board assembly) 341, 343, a battery 350, a second support member 360 (e.g., a rear case), an antenna, a camera assembly 307, and a rear plate 380 (e.g., the rear plate 211 of FIG. 2). When the plurality of printed circuit boards 341, 343 are included, the electronic device 101 may include at least one flexible printed circuit board 345 to electrically connect different printed circuit boards. For example, the printed circuit boards 341 and 343 may include a first circuit board 341 disposed above the battery 350 (e.g., in the +Y-axis direction) and a second circuit board 343 disposed under the battery 350 (e.g., in the -Y-axis direction), and the flexible printed circuit board 345 may electrically connect the first circuit board 341 and the second circuit board 343.

According to an embodiment, the electronic device 101 may exclude at least one (e.g., the first support member 311 or the second support member 360) of the components or may add other components. At least one of the components of the electronic device 101 may be the same or similar to at least one of the components of the electronic device 101 of FIGS. 1 to 3 and no duplicate description is made below.

According to an embodiment, at least a portion of the first support member 311 may be provided in a flat plate shape. In an embodiment, the first support member 311 may be disposed inside the electronic device 101 to be connected with the side structure 310 or integrated with the side structure 310. The first support member 311 may be formed of, e.g., a metallic material and/or non-metal material (e.g., polymer). When the first support member 311 is at least partially formed of a metallic material, a portion of the side structure 310 or the first support member 311 may function as an antenna. The display 330 may be joined onto one surface of the first support member 311, and the printed circuit boards 341 and 343 may be joined onto the opposite surface of the first support member 311. A processor, memory, and/or interface may be mounted on the printed circuit boards 341 and 343. The processor may include one or more of, e.g., a central processing unit, an application processor, a graphic processing device, an image signal processing, a sensor hub processor, or a communication processor.

According to an embodiment, the first support member 311 and the side structure 310 may be collectively referred to as a front case or a housing 301. According to an embodiment, the housing 301 may be generally understood as a structure for receiving, protecting, or disposing the printed circuit boards 341 and 343 or the battery 350. In an embodiment, the housing 301 may be understood as including a structure that the user may visually or tactfully recognize from the outside of the electronic device 101, e.g., the side structure 310, the front plate 320, and/or the rear plate 380. In an embodiment, the 'front or rear surface of the housing 301' may refer to the first surface 210A of FIG. 2 or the second surface 210B of FIG. 3. In an embodiment, the first support member 311 may be disposed between the front plate 320 (e.g., the first surface 210A of FIG. 2) and the rear plate 380 (e.g., the second surface 210B of FIG. 3) and may function as a structure for placing an electrical/electronic component, such as the printed circuit boards 341 and 343 or the camera assembly 307.

According to an embodiment, a side structure 310 may include at least one side wall 3101, 3102, 3103, 3004. The at least one side wall 3101, 3102, 3103, 3104 may include a first side wall 3101, a second side wall 3102, a third side wall 3103, or a fourth side wall 3104. The at least one side wall 3101, 3102, 3103, 3104 may be defined and/or referred to as at least one side surface.

According to an embodiment, the first side wall 3101 may be defined and/or referred to as a lower wall of the electronic device 101.

According to an embodiment, the second side wall 3102 may extend from the first side wall 3101 and may be disposed substantially perpendicular to the first side wall 3101. For example, the second side wall 3102 may extend from one end (e.g., an end facing the -X direction in FIGS. 4 to 5) of the first side wall 3101.

According to an embodiment, the third side wall 3103 may extend from the first side wall 3101 and may be disposed substantially perpendicular to the first side wall 3101. For example, the third side wall 3103 may extend from the other end (e.g., an end facing the +X direction in FIGS. 4 to 5) of the first side wall 3101. The third side wall 3103 may be disposed substantially parallel to the second side wall 3102.

According to an embodiment, the fourth side wall 3104 may be defined and/or referred to as an upper wall of the electronic device 101.

According to an embodiment, the fourth side wall 3104 may extend from one end (e.g., an end facing the +Y direction in FIGS. 4 to 5) of the second side wall 3102. The fourth side wall 3104 may extend from one end (e.g., an end facing the +Y direction in FIGS. 4 to 5) of the second side wall 3102.

According to an embodiment, the fourth side wall 3104 may be disposed substantially perpendicular to the second side wall 3102 and/or the third side wall 3103. Further, the fourth side wall 3104 may be disposed substantially parallel to the first side wall 3101.

According to an embodiment, the first side wall 3101, the second side wall 3102, the third side wall 3103, and the fourth side wall 3104 may each include an inner surface facing the interior of the electronic device 101 and an outer surface facing the exterior of the electronic device 101.

According to an embodiment, the first side wall 3101, the second side wall 3102, the third side wall 3103, and the fourth side wall 3104 may be integrally formed. According to an embodiment, the first side wall 3101, the second side wall 3102, the third side wall 3103, and the fourth side wall 3104 may each be manufactured as separate members and assembled into one side structure 310.

According to an embodiment, the first side wall 3101, the second side wall 3102, the third side wall 3103, and the fourth side wall 3104 may each be formed of a metal material and/or a non-metal material (e.g., polymer).

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment, the second support member 360 may include, e.g., an upper support member 360a and a lower support member 360b. In an embodiment, the upper support member 360a, together with a portion of the first support member 311, may be disposed to surround the printed circuit boards 341 and 343 (e.g., the first circuit board 341). For example, the upper support member 360a of the second support member 360 may be disposed to face the first support member 311 with the first circuit board 341 interposed therebetween. In an embodiment, the lower support member 360b of the second support member 360 may be disposed to face the first support member 311 with the second circuit board 343 interposed therebetween. A circuit device (e.g., a processor, a communication module, or memory) implemented in the form of an integrated circuit chip or various electrical/electronic components may be disposed on the printed circuit boards 341 and 343. According to an embodiment, the printed circuit boards 341 and 343 may receive an electromagnetic shielding environment from the second support member 360. In an embodiment, the lower support member 360b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). For example, the lower support member 360b, together with the other part of the first support member 311, may be disposed to surround the additional printed circuit board. The speaker module or interface disposed on the additional printed circuit board (not shown) or the lower support member 360b may be disposed corresponding to the audio module 207 or connector holes 208 and 209 of FIG. 2.

According to an embodiment, the battery 350 may be a device for supplying power to at least one component of the electronic device 101. The battery 350 may include, e.g., a primary cell which is not rechargeable, a secondary cell which is rechargeable, or a fuel cell. At least a portion of the battery 350 may be disposed on substantially the same plane as the printed circuit boards 341 and 343. The battery 350 may be integrally or detachably disposed inside the electronic device 101.

Although not shown, the antenna may include a conductor pattern implemented on the surface of the second support member 360 through, e.g., laser direct structuring. In an embodiment, the antenna may include a printed circuit pattern formed on the surface of the thin film. The thin film-type antenna may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 310 and/or the first support member 311.

According to an embodiment, the camera assembly 307 may include at least one camera module. Inside the electronic device 101, the camera assembly 307 (or at least one camera module) may receive at least a portion of the light incident through the optical hole or the camera windows 312, 313, and 319. In an embodiment, the camera assembly 307 may be disposed on the first support member 311 in a position adjacent to the printed circuit boards 341 and 343. In an embodiment, the camera module(s) of the camera assembly 307 may be generally aligned with either one of the camera windows 312, 313, and 319 and be at least partially surrounded by the second support member 360 (e.g., the upper support member 360a).

FIG. 6 is a front view illustrating an electronic device including an antenna module according to an embodiment of the disclosure.

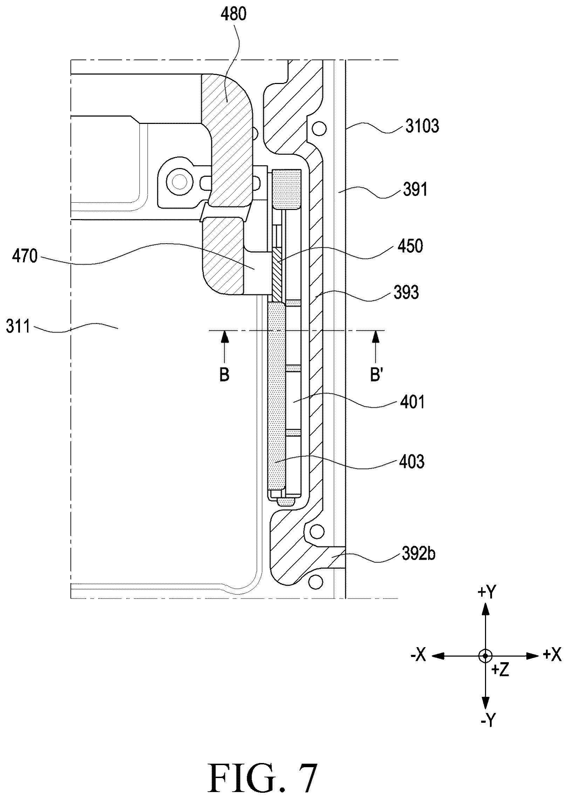

FIG. 7 is an enlarged view illustrating portion "A" of FIG. 6 according to an embodiment of the disclosure.

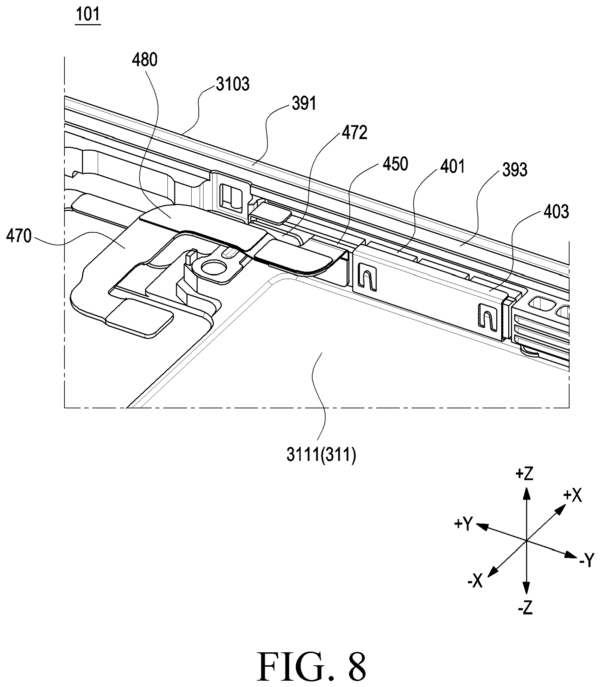

FIG. 8 is a perspective view illustrating an electronic device including an antenna module according to an embodiment of the disclosure.

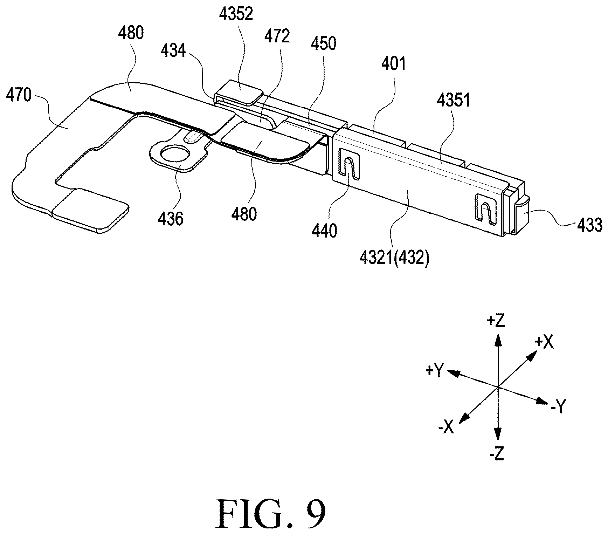

FIG. 9 is a perspective view illustrating an antenna module and a conductive support member according to an embodiment of the disclosure.

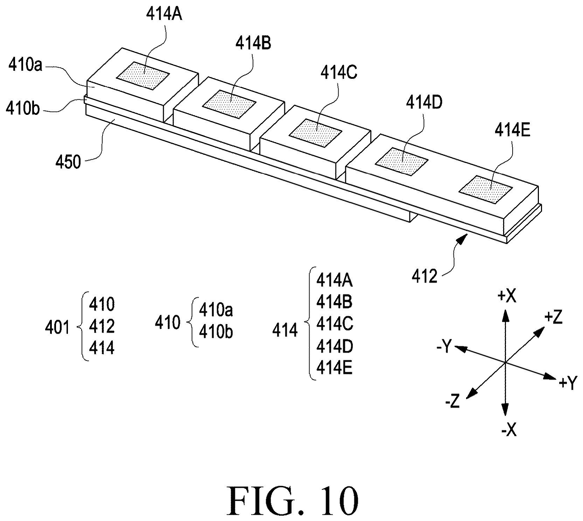

FIG. 10 is a perspective view illustrating an antenna module according to an embodiment of the disclosure.

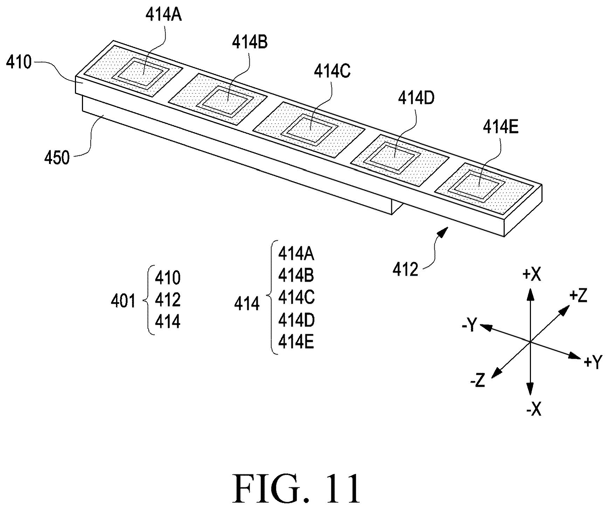

FIG. 11 is a perspective view illustrating an antenna module according to an embodiment of the disclosure.

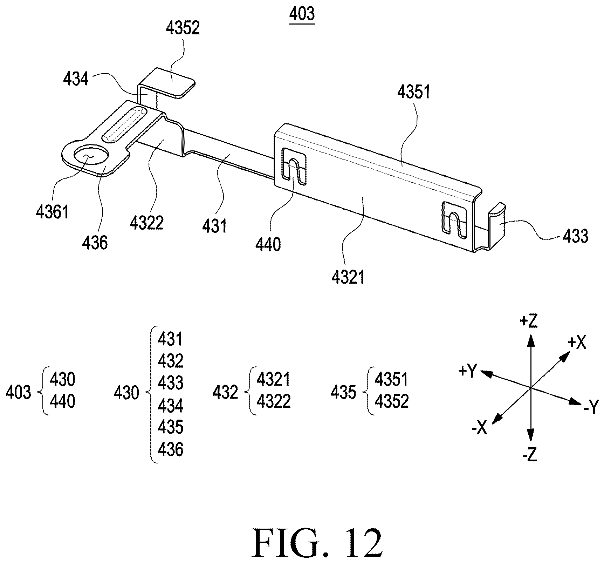

FIG. 12 is a perspective view illustrating a conductive support member according to an embodiment of the disclosure.

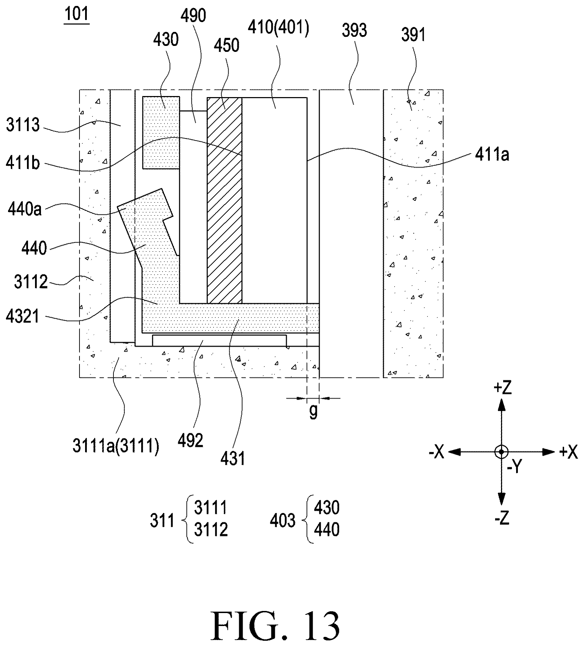

The embodiments of FIGS. 6 and 12 may be combined with the embodiments of FIGS. 1 to 5 or the embodiments of FIGS. 13 to 27.

Referring to FIGS. 6 to 12, an electronic device 101 (e.g., the electronic device 101 of FIGS. 1 to 5) may include a housing 301, a side structure 310, a first support member 311, an antenna module 401, a conductive support member 403, a shielding member 450, a conductive connecting member 470, or a reinforcing member 480. The housing 301 may include the first support member 311, or the side structure 310. The side structure 310 may include a second side wall 3102, a third side wall 3103, or a fourth side wall 3104.

The configuration of the housing 301, the side structure 310, the first support member 311, the second side wall 3102, the third side wall 3103, or the fourth side wall 3104 of FIGS. 6 to 8 may be identical in whole or part to the configuration of the housing 301, the side structure 310, the first support member 311, the second side wall 3102, the third side wall 3103, or the fourth side wall 3104 of FIGS. 4 to 5.

According to an embodiment, the electronic device 101 may include at least one antenna structure 391. The at least one antenna structure 391 may form at least a portion of the housing 301. For example, at least one antenna structure 391 may form at least a portion of the side structure 310. According to the illustrated embodiment, at least one antenna structure 391 may be formed or positioned on at least a portion of the third side wall 3103 but, without limitations thereto, may be formed or positioned on another portion of the housing 301. An antenna structure 391 may be defined and/or referred to as a metal antenna, a metal housing antenna, or a segmentation antenna.

According to an embodiment, at least one antenna structure 391 may be formed of a metal material. At least one antenna structure 391 may be defined and/or interpreted as at least a portion of the third side wall 3103. The at least one antenna structure 391 may not be electrically connected to other portions of the third side wall 3103 by non-conductive portions 392a, 392b. The non-conductive portions 392a, 392b may be provided as a pair of non-conductive portions 392a, 392b connected to opposite ends of at least one antenna structure 391, but the disclosure is not limited thereto. The non-conductive portions 392a, 392b may be formed of a non-metal material (e.g., polymer). The non-conductive portions 392a, 392b may be coupled to the at least one antenna structure 391 through an injection process.

According to an embodiment, at least a portion of the housing 301 of the electronic device 101 may be formed of a non-metal material (e.g., polymer). For example, at least a portion of the side structure 310 may include a non-metal area 393 formed of a non-metal material. The non-metal area 393 may form at least a portion of the side structure 310, and the remainder of the side structure 310 may be provided as a metal area formed of a metal material. At least a portion of the non-metal area 393 may be positioned between the third side wall 3103 and the antenna module 401. The non-conductive portions 392a, 392b may be defined and/or interpreted as partial components of the non-metal area 393.

According to an embodiment, at least one antenna structure 391 may be separated from other metal portions of the third side wall 3103 by the non-conductive portion. The at least one antenna structure 391 may be defined and/or referred to as a segmentation antenna, a side wall antenna, a metal antenna, or a metal housing antenna. At least one antenna structure 391 may be configured to transmit and/or receive a radio frequency (RF) signal of a designated frequency band with an external electronic device 101. The frequency band of the RF signal of the at least one antenna structure 391 may be different from the frequency band of the RF signal of the antenna module 401, but the disclosure is not limited thereto.

According to an embodiment, the electronic device 101 may further include a feeding portion, or a ground portion. The feeding portion may include a conductive path (e.g., a coaxial cable, or a flexible printed circuit board (FPCB)), and the conductive path of the feeding portion may be electrically connected to a communication module (e.g., the communication module 190 of FIG. 1) mounted on (or disposed on) a first circuit board (e.g., the first circuit board 341 of FIGS. 4 to 5). The feeding portion may include a connecting member (e.g., a c-clip) that electrically connects the conductive path and the at least one antenna structure 391. The ground portion may include a conductive path (e.g., a coaxial cable, or an FPCB), and the conductive path of the ground portion may be electrically connected to a ground plane of a first circuit board (e.g., the first circuit board 341 of FIGS. 4 to 5). The ground portion may include a connecting member (e.g., a c-clip) that electrically connects the conductive path and the at least one antenna structure 391. The feeding portion may be configured to provide a feeding signal to at least one metal antenna, and a ground portion may be configured to provide ground to at least one antenna structure 391.

According to an embodiment, the antenna module 401 may be disposed inside the housing 301. The antenna module 401 may be disposed, e.g., at least partially adjacent to the side structure 310. The antenna module 401 may be disposed to form a beam toward the exterior of the housing 301. The antenna module 401 may include an antenna array 414 and may be configured to radiate an RF signal in the direction that the antenna array 414 faces. According to the illustrated embodiment, the antenna module 401 is disposed or positioned adjacent to the third side wall 3103, but the position of the antenna module 401 is not limited thereto and may have various positions. The antenna module 401 and/or the antenna array 414 of the antenna module 401 may be disposed to face at least one antenna structure 391.

According to an embodiment, the antenna array 414 of the antenna module 401 may be disposed to face the exterior of the housing 301. According to the illustrated embodiment, the antenna array 414 of the antenna module 401 is disposed to face the direction that the third side wall 3103 faces (e.g., the +X direction in FIGS. 6 to 7)but, without limitations thereto, may be disposed to face a rear plate (e.g., the rear plate 380 of FIGS. 4 to 5) of the housing 301.

According to an embodiment, the antenna module 401 may overlap at least one antenna structure 391 with respect to the width direction (e.g., the X-axis direction in FIGS. 6 to 7) of the electronic device 101. The antenna module 401 may be electrically connected to a first circuit board (e.g., the first circuit board 341 of FIGS. 4 to 5) through a conductive connecting member 470.

Referring to FIGS. 10 to 11, the antenna module 401 may include the substrate 410, or the antenna array 414 disposed on a first surface of the substrate 410. The antenna array 414 may include a plurality of antenna elements 414A, 414B, 414C, 414D, 414E disposed on a first surface of the substrate 410. The plurality of antenna elements 414A, 414B, 414C, 414D, 414E may be defined and/or referred to as a plurality of radiation patches. According to the illustrated embodiment, the plurality of antenna elements 414A, 414B, 414C, 414D, 414E are illustrated as five, but are not limited thereto and may be provided in various numbers.

According to an embodiment, the substrate 410 may be defined and/or referred to as an antenna substrate 410. The substrate 410 may include at least one of a printed circuit board (PCB) 410, a flexible printed circuit board (FPCB) 410, or a rigid-flexible PCB (RF-PCB).

According to an embodiment, the antenna array 414 may be disposed or mounted on one surface (e.g., a surface facing the +X direction in FIGS. 6 to 12) of the substrate 410. At least one electrical component may be disposed or mounted on the other surface (e.g., a surface facing the -X direction in FIGS. 6 to 12) opposite to the one surface of the substrate 410. The at least one electrical component may include a radio frequency integrated circuit (RFIC) electrically connected to the antenna array 414. The RFIC may be defined and/or referred to as a communication circuit.

According to an embodiment, the antenna module 401 may be configured to transmit and/or receive an RF signal with an external electronic device 101 through the antenna array 414. The frequency band of the RF signal of the antenna module 401 may be different from the frequency band of the RF signal of at least one antenna structure 391, but the disclosure is not limited thereto. The RF signal provided by the antenna module 401 may have a frequency band of a millimeter wave (mmWave) band, but the disclosure is not limited thereto.

Referring to FIG. 10, the substrate 410 may include a first substrate 410a, or a second substrate 410b. The first substrate 410a may be provided as a plurality of first substrates 410a. The antenna array 414 may be disposed or mounted on the first substrate 410a. One surface of the first substrate 410a on which the antenna array 414 is mounted may be defined and/or referred to as a first surface of the substrate 410. A communication circuit may be disposed or mounted on the second substrate 410b. The second substrate 410b may be stacked on the first substrate 410a. The second substrate 410b may be electrically connected to the first substrate 410a. One surface of the second substrate 410b may be defined and/or referred to as a second surface of the substrate 410. The communication circuit may be disposed or mounted on the second surface of the substrate 410. The second surface of the substrate 410 or the second substrate 410b may face a rear support portion (e.g., the second support portion 432) of the conductive support member 403. The second surface of the substrate 410 may face in a direction opposite to the first surface of the substrate 410. At least a portion of the second surface of the substrate 410 may be covered by the shielding member 450. The substrate 410 may include a first connector 412 disposed on the second surface of the substrate 410. The first connector 412 may include a board-to-board connector (B2B connector) and may be physically and/or electrically connected to a second connector 472 of the conductive connecting member 470. According to an embodiment, the substrate 410 may be provided as a plurality of substrates 410a, 410bbut, without limitations thereto, may be provided as one substrate 410 as illustrated in FIG. 11.

Referring to FIG. 11, the antenna array 414 may be disposed or mounted on one surface (e.g., a surface facing the +X direction in FIG. 11) of the substrate 410, and the one surface of the substrate 410 may be defined and/or referred to as a first surface of the substrate 410. A communication circuit may be disposed or mounted on the other surface (e.g., a surface facing the -X direction in FIG. 11) of the substrate 410, and the other surface of the substrate 410 may be defined and/or referred to as a second surface of the substrate 410. At least a portion of the second surface of the substrate 410 may be covered by the shielding member 450. The substrate 410 may include a first connector 412 disposed on the second surface of the substrate 410. The first connector 412 may include a board-to-board connector (B2B connector) and may be physically and/or electrically connected to a second connector 472 of the conductive connecting member 470. The substrate 410 may include a first connector 412 disposed on the second surface of the substrate 410. The first connector 412 may include a board-to-board connector (B2B connector) and may be physically and/or electrically connected to a second connector 472 of the conductive connecting member 470.

According to an embodiment, the reinforcing member 480 may be stacked on one surface of the conductive connecting member 470. The reinforcing member 480 may reduce or limit transmission of impact acting from the exterior of the electronic device 101 to the conductive connecting member 470. For example, the reinforcing member 480 may include a stiffener configured to limit or prevent excessive deformation of the conductive connecting member 470.

Hereinafter, the antenna module 401 of the disclosure is described using the substrate 410 of FIG. 11 as an example, but the description thereof may be equally and/or similarly applied and/or understood when the substrate 410 is provided as a plurality of substrates 410a, 410b as illustrated in FIG. 10.

According to an embodiment, the electronic device 101 and/or the housing 301 may include a ground area (e.g., the ground area 3113 of FIG. 13). For example, the first support member 311 may include a ground area electrically connected to a contacting portion 440 of the conductive support member 403.

According to an embodiment, the electronic device 101 may include the shielding member 450 coupled to at least a portion of the second surface of the antenna module 401. The shielding member 450 may be electrically connected to a ground area (e.g., the ground area 3113 of FIG. 13) of the electronic device 101. A shielding member 450 may be provided with a ground plane from the ground area. The shielding member 450 may be coupled to or disposed on the second surface (e.g., a surface facing the -X direction in FIGS. 6 to 12) of the substrate 410.

According to an embodiment, the shielding member 450 may block or reduce electromagnetic interference from other adjacent electrical/electronic components inside the electronic device 101 to the communication circuit. For example, electromagnetic waves generated from surrounding electrical/electronic components may act as noise to the communication circuit or the antenna module 401. Further, electromagnetic waves generated from the communication circuit and/or the antenna module 401 may act as noise to surrounding electrical/electronic components. The shielding member 450 may guide electromagnetic waves to the ground area by being electrically connected to the ground area of the electronic device 101. Accordingly, the shielding member 450 may provide a shielding function by blocking electromagnetic interference between the antenna module 401 and/or the communication circuit and surrounding electrical/electronic components. The shielding member 450 may be formed of a metal material. For example, the shielding member 450 may include a metal plate, a metal thin film, and/or a conductive sheet. A shielding member 450 may be defined and/or referred to as a shield-can.

According to an embodiment, the shielding member 450 may be electrically connected to the ground area of the electronic device 101 through the conductive support member 403.

According to an embodiment, the electronic device 101 may further include a conductive connecting member 470. The conductive connecting member 470 may include a second connector 472 configured to be physically and/or electrically connected to the first connector 412 of the substrate 410 of the antenna module 401. The second connector 472 may include a B2B connector. The conductive connecting member 470 may be electrically connected to a main circuit board (e.g., the first circuit board 341 of FIGS. 4 to 5) and/or the antenna module 401.

According to an embodiment, the conductive connecting member 470 may be electrically connected to a main circuit board (e.g., the first circuit board 341 of FIGS. 4 to 5) of the electronic device 101. The conductive connecting member 470 may include at least one of a coaxial cable or a flexible printed circuit board (FPCB) 410.

Hereinafter, for convenience of description of the configurations of the antenna module 401, the conductive support member 403, and/or the shielding member 450 of FIGS. 6 to 15, among the directions of the illustrated orthogonal coordinate system, the +X direction may be defined and/or referred to as a front direction of the antenna module 401, the conductive support member 403, and/or the shielding member 450. The front direction may be a direction that the antenna array 414 faces. The -X direction may be defined and/or referred to as a rear direction of the antenna module 401, the conductive support member 403, and/or the shielding member 450. The +Z direction may be defined and/or referred to as an upward-facing lateral direction among the sides of the antenna module 401, the conductive support member 403, and/or the shielding member 450. The -Z direction may be defined and/or referred to as a downward-facing lateral direction among the sides of the antenna module 401, the conductive support member 403, and/or the shielding member 450. The +Y direction may be defined and/or referred to as a left-facing lateral direction among the sides of the antenna module 401, the conductive support member 403, and/or the shielding member 450. The -Y direction may be defined and/or referred to as a right-facing lateral direction among the sides of the antenna module 401, the conductive support member 403, and/or the shielding member 450. The directions are based on the orthogonal coordinate system illustrated in the drawings for brevity of description, and it should be noted that such directions or descriptions of components do not limit the embodiments of the disclosure. For example, the above-described directions may be interpreted differently depending on a user's gripping habit or the direction that the antenna array faces.

According to an embodiment, the electronic device 101 may further include a conductive support member 403. The conductive support member 403 may support at least a portion of the antenna module 401. The conductive support member 403 may surround at least a portion of the antenna module 401 and may fix the position of the antenna module 401 inside the electronic device 101. The conductive support member 403 may be fixed to at least a portion of the housing 301. The conductive support member 403 may be formed of a conductive material capable of conducting electricity, or a metal material.

According to an embodiment, at least a portion of the conductive support member 403 may be electrically connected to a ground area (e.g., the ground area 3113 of FIG. 13) of the electronic device 101. The conductive support member 403 may be electrically connected to at least a portion of the shielding member 450. For example, the conductive support member 403 may provide a conductive path electrically connecting the shielding member 450 and the ground area.

According to an embodiment, the conductive support member 403 may be formed to cover at least a portion of the antenna module 401. The conductive support member 403 may have a shape that allows one surface of the substrate 410 on which the antenna array 414 of the antenna module 401 is formed to be open. For example, the conductive support member 403 may be provided in a shape that does not cover one surface of the substrate 410 on which the antenna array 414 of the antenna module 401 is formed.

According to an embodiment, the conductive support member 403 may include a bracket 430, or a contacting portion 440. According to an embodiment, the contacting portion 440 may be integrally formed with the bracket 430.

According to an embodiment, the bracket 430 may be configured to support the antenna module 401 and/or the shielding member 450. The bracket 430 may surround at least a portion of the substrate 410. For example, the bracket 430 may be connected to or coupled to at least a portion of the antenna module 401 and/or at least a portion of the shielding member 450. The bracket 430 may couple or fix the antenna module 401 and/or the shielding member 450 to the housing 301.

According to an embodiment, the bracket 430 may surround at least one surface of the substrate facing a direction different from the direction (e.g., the +X direction in FIGS. 6 to 12) that the first surface (e.g., a surface facing the +X direction in FIGS. 6 to 12) of the substrate 410 faces (e.g., a surface facing the -X direction, +Y direction, -Y direction, +Z direction, or -Z direction in FIGS. 6 to 12).

According to an embodiment, the bracket 430 may include a plurality of support portions 431, 432, 433, 434, 435 configured to support surfaces of the substrate 410 facing directions different from the direction (e.g., the +X direction in FIGS. 6 to 12) that the first surface (e.g., a surface facing the +X direction in FIGS. 6 to 12) of the substrate 410 faces (e.g., surfaces facing the -X direction, +Y direction, -Y direction, +Z direction, and -Z direction in FIGS. 6 to 12). The surfaces of the substrate 410 may be defined and/or referred to as outer surfaces of the substrate 410 facing directions different from the first surface.

According to an embodiment, a plurality of support portions 431, 432, 433, 434, 435 may include a first support portion 431, a second support portion 432, a third support portion 433, a fourth support portion 434, a fifth support portion 435, or a connection portion 436. The first support portion 431, the second support portion 432, the third support portion 433, the fourth support portion 434, the fifth support portion 435, and the connection portion 436 may be integrally formed, but the disclosure is not limited thereto. The support portion(s) 431, 432, 433, 434, 435 may be defined and/or referred to as support panel(s), support plate(s), support area(s), or cover portion(s).

According to an embodiment, the first support portion 431 may contact or be connected to a downward-facing side surface (e.g., a surface facing the -Z direction in FIGS. 6 to 12) among the side surfaces of the substrate 410 of the antenna module 401, and may be configured to support the side surface. The first support portion 431 may be connected to or coupled to the second support portion 432, the third support portion 433, or the fourth support portion 434. The first support portion 431 may be defined and/or referred to as a base support portion, or a lower support portion.

According to an embodiment, the second support portion 432 may extend upward from the first support portion 431. The second support portion 432 may contact or be connected to a rear surface (e.g., a surface facing the -X direction in FIGS. 6 to 12, or a second surface) of the substrate 410 of the antenna module 401, and/or a rear surface (e.g., a surface facing the -X direction in FIGS. 6 to 12) of the shielding member 450, and may be configured to support the rear surface of the substrate 410, and/or the rear surface of the shielding member 450. The second support portion 432 may be connected to the first support portion 431 and the fifth support portion 435.

According to an embodiment, the second support portion 432 may be provided in a bent shape with respect to the first support portion 431, but the disclosure is not limited thereto.

According to an embodiment, the second support portion 432 may include a 2-1th support portion 4321, and a 2-2th support portion 4322 spaced apart from the 2-1th support portion 4321. At least a portion of the conductive connecting member 470 may be positioned between the 2-1th support portion 4321 and the 2-2th support portion 4322.

According to an embodiment, the 2-1th support portion 4321 may be connected to or coupled to the first support portion 431 and the 5-1th support portion 4351. The 2-2th support portion 4322 may be connected to or coupled to the first support portion 431 and the connection portion 436.

According to an embodiment, the third support portion 433 may extend upward from the first support portion 431. The third support portion 433 may contact or be connected to a right-facing side surface (e.g., a side surface facing the -Y direction in FIGS. 6 to 12) among the side surfaces of the substrate 410 of the antenna module 401, and/or a right-facing side surface (e.g., a side surface facing the -Y direction in FIGS. 6 to 12) among the side surfaces of the shielding member 450. The third support portion 433 may be configured to support the right-facing side surface of the antenna module 401 and the right-facing side surface of the shielding member 450. The third support portion 433 may be connected to the first support portion 431. The third support portion 433 may be spaced apart from the fourth support portion 434 and may face the fourth support portion 434. One surface of the third support portion 433 facing the fourth support portion 434 may be parallel to one surface of the fourth support portion 434 facing the third support portion 433.

According to an embodiment, the third support portion 433 may be provided in a bent shape with respect to the first support portion 431, but the disclosure is not limited thereto.

According to an embodiment, the fourth support portion 434 may extend upward from the first support portion 431. The fourth support portion 434 may contact or be connected to a left-facing side surface (e.g., a side surface facing the +Y direction in FIGS. 6 to 12) among the side surfaces of the substrate 410 of the antenna module 401, and/or a left-facing side surface (e.g., a side surface facing the +Y direction in FIGS. 6 to 12) among the side surfaces of the shielding member 450. The fourth support portion 434 may be configured to support the left-facing side surface of the antenna module 401 and the left-facing side surface of the shielding member 450. The fourth support portion 434 may be connected to the first support portion 431 and the 5-2th support portion 4352. The fourth support portion 434 may be spaced apart from the third support portion 433 and may face the third support portion 433. One surface of the fourth support portion 434 facing the third support portion 433 may be parallel to one surface of the third support portion 433 facing the fourth support portion 434.

According to an embodiment, the third support portion 433 may be provided in a bent shape with respect to the first support portion 431, but the disclosure is not limited thereto.

According to an embodiment, the fifth support portion 435 may extend forward from the second support portion 432, or may extend from the fourth support portion 434 toward the third support portion 433. The fifth support portion 435 may contact or be connected to an upward-facing side surface (e.g., a surface facing the +Z direction in FIGS. 6 to 12) of the substrate 410 of the antenna module 401, and/or an upward-facing side surface (e.g., a surface facing the +Z direction in FIGS. 6 to 12) of the shielding member 450, and may be configured to support the upward-facing side surface of the substrate 410, and/or the upward-facing side surface of the shielding member 450.

According to an embodiment, the fifth support portion 435 may include a 5-1th support portion 4351, and a 5-2th support portion 4352 spaced apart from the 5-1th support portion 4351.

According to an embodiment, the 5-1th support portion 4351 may be connected to or coupled to the 2-1th support portion 4321. The 5-1th support portion 4351 may be provided in a bent shape with respect to the 2-1th support portion 4321, but the disclosure is not limited thereto. The 5-2th support portion 4352 may be connected to or coupled to the fourth support portion 434. The 5-1th support portion 4351 may be provided in a bent shape with respect to the 2-1th support portion 4321, but the disclosure is not limited thereto. The 5-2th support portion 4352 may be provided in a bent shape with respect to the fourth support portion 434, but the disclosure is not limited thereto.

According to an embodiment, the connection portion 436 may extend rearward from the 2-2th support portion 4322. For example, the connection portion 436 may be provided in a bent shape with respect to the 2-2th support portion 4322, but the disclosure is not limited thereto. The connection portion 436 may be fixed to at least a portion of the housing 301. The connection portion 436 may include a connection hole 4361 formed through at least a portion of the connection portion 436. A fastening member (e.g., a bolt, a screw, or a pin) may be inserted into the connection hole 4361, and the connection portion 436 may be fixed to at least a portion of the housing 301 through the fastening member. According to the illustrated embodiment, one connection portion 436 is provided, but the conductive support member 403 may include a plurality of connection portions 436.

According to an embodiment, the contacting portion 440 may be integrally formed with the bracket 430. The contacting portion 440 may protrude from at least a portion of the bracket 430 toward the outside of the bracket 430. The contacting portion 440 may be electrically connected to a ground area (e.g., the ground area 3113 of FIG. 13) of the electronic device 101. The contacting portion 440 may contact the ground area. The contacting portion 440 may be formed by bending at least a portion of the bracket 430.

According to an embodiment, the contacting portion 440 may be formed on at least one of the plurality of support portions 431, 432, 433, 434, 435.

According to an embodiment, the contacting portion 440 and the conductive support member 403 including the same may provide a conductive path for the shielding member 450. For example, the shielding member 450 may be electrically connected to the ground area of the electronic device 101 through the contacting portion 440 and the conductive support member 403. The ground area of the electronic device 101 may provide a ground plane for the shielding member 450.

According to an embodiment, the first support member 311 of the housing 301 may include a planar support portion 3111 (e.g., the planar support portion 3111 of FIGS. 13 to 14) disposed parallel to a display (e.g., the display 330 of FIGS. 4 to 5) and/or a rear plate (e.g., the rear plate 380 of FIGS. 4 to 5) of the electronic device 101. The first support member 311 may include a vertical support portion (e.g., the vertical support portion 3112 of FIGS. 13 to 14) extending from the planar support portion 3111 toward the display 330 and/or the rear plate 380. The vertical support portion (e.g., the vertical support portion 3112 of FIGS. 13 to 14) may support at least a portion of the second support portion 432 of the bracket 430 of the conductive support member 403. At least a portion of the first support member 311 may be physically connected to the contacting portion 440 of the conductive support member 403 and may be electrically connected to the contacting portion 440 of the conductive support member 403. The contacting portion 440 may be positioned at the second support portion 432. For example, the contacting portion 440 may be formed on at least a portion of the 2-1th support portion 4321. The contacting portion 440 may extend at least partially toward the top (e.g., the +Z direction in FIGS. 6 to 12) of the conductive support member 403 from at least a portion of the 2-1th support portion 4321but, without limitations thereto, may extend at least partially toward various directions.

FIG. 13 is a cross-sectional view illustrating an electronic device taken along line B-B' of FIG. 7 according to an embodiment of the disclosure.

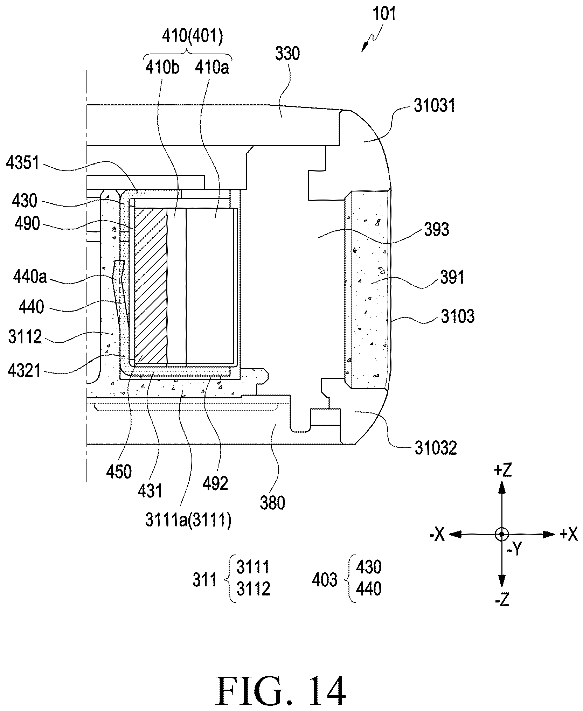

FIG. 14 is a cross-sectional view illustrating an electronic device taken along line B-B' of FIG. 7 according to an embodiment of the disclosure.

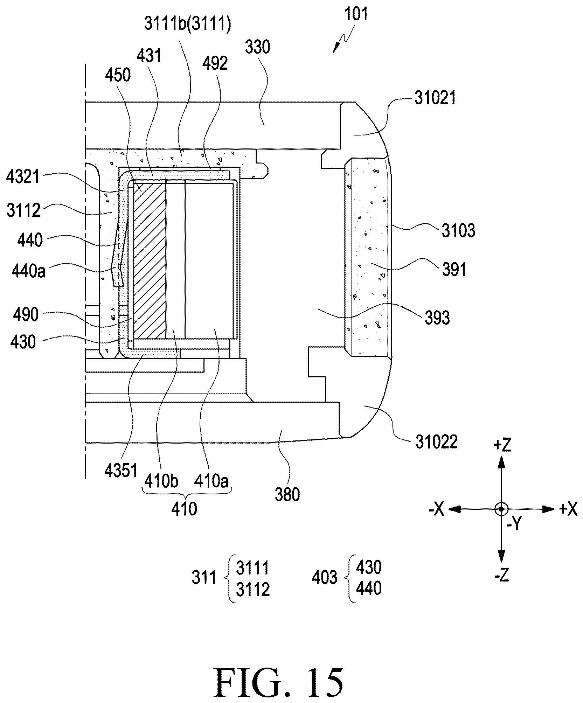

FIG. 15 is a cross-sectional view illustrating an electronic device according to an embodiment of the disclosure.

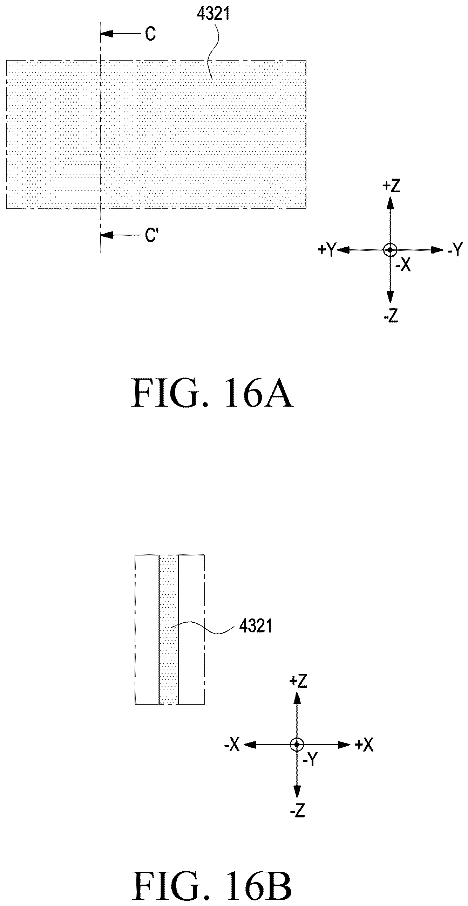

The embodiments of FIGS. 13 to 15 may be combined with the embodiments of FIGS. 1 to 14, or the embodiments of FIGS. 16A to 27.

Referring to FIGS. 13 to 15, an electronic device 101 (e.g., the electronic device 101 of FIGS. 2 to 6) may include a first support member 311, a planar support portion 3111, at least one antenna structure 391, a non-metal area 393, an antenna module 401, a substrate 410, a conductive support member 403, a bracket 430, a 2-1th support portion 4321, a contacting portion 440, or a shielding member 450.

The configuration of the first support member 311, the planar support portion 3111, at least one antenna structure 391, the non-metal area 393, the antenna module 401, the substrate 410, the conductive support member 403, the bracket 430, the 2-1th support portion 4321, the contacting portion 440, or the shielding member 450 of FIGS. 13 to 15 may be identical in whole or part to the configuration of the first support member 311, the planar support portion 3111, at least one antenna structure 391, the non-metal area 393, the antenna module 401, the substrate 410, the conductive support member 403, the bracket 430, the 2-1th support portion 4321, the contacting portion 440, or the shielding member 450 of FIGS. 6 to 12.

According to an embodiment, the electronic device 101 may further include a first adhesive member 490 that adheres the shielding member 450 and the conductive support member 403. The first adhesive member 490 may include a conductive double-sided tape that electrically connects the shielding member 450 and the conductive support member 403. One surface of the first adhesive member 490 may be adhered to the rear surface of the shielding member 450, and the other surface of the first adhesive member 490 opposite to the one surface may be adhered to the 2-1th support portion 4321 of the bracket 430 of the conductive support member 403.

According to an embodiment, the first adhesive member 490 may provide a conductive path electrically connecting the shielding member 450 and the conductive support member 403.

According to an embodiment, the planar support portion 3111 may include a seating portion 3111a on which at least a portion of the conductive support member 403 is seated. The seating portion 3111a may be configured to support at least a portion of the conductive support member 403.

According to an embodiment, the electronic device 101 may further include a second adhesive member 492 that adheres the seating portion 3111a and the conductive support member 403. The second adhesive member 492 may include a conductive double-sided tape that electrically connects the seating portion 3111a and the conductive support member 403. One surface of the second adhesive member 492 may be adhered to the seating portion 3111a, and the other surface of the second adhesive member 492 opposite to the one surface may be adhered to the first support portion 431 of the bracket 430 of the conductive support member 403.

According to an embodiment, the substrate 410 of the antenna module 401 may include a first surface 411a and a second surface 411b facing a direction opposite to the first surface 411a. The first surface 411a of the substrate 410 may be defined and/or referred to as a front surface of the substrate 410, and the antenna array 414 may be disposed or mounted on the first surface 411a of the substrate 410. The second surface 411b of the substrate 410 may be defined and/or referred to as a rear surface of the substrate 410, and a communication circuit may be disposed or mounted on the second surface 411b of the substrate 410.

According to an embodiment, the first surface 411a of the substrate 410 may be disposed to face the exterior of the electronic device 101. For example, the antenna array 414 disposed on the first surface 411a may face the exterior of the electronic device 101. The first surface 411a of the substrate 410 may face the non-metal area 393 and/or at least one antenna structure 391.

According to an embodiment, the bracket 430 may be inserted between the non-metal area 393 and the vertical support portion 3112 in an interference fit manner. As the bracket 430 is inserted between the non-metal area 393 and the vertical support portion 3112 in an interference fit manner, the contacting portion 440 may be at least partially elastically deformed when closely contacted with the ground area 3113. According to an embodiment, the contacting portion 440 may be defined and/or referred to as a protruding portion.

According to an embodiment, the first surface 411a of the substrate 410 may be spaced apart from the non-metal area 393. For example, the first surface 411a of the substrate 410 may be spaced apart from the non-metal area 393 by a first distance g with respect to the width direction (e.g., the X-axis direction in FIG. 13) of the electronic device 101. The first distance g may be about 0.45 mm to about 0.55 mm. For example, the first distance g may be about 0.5 mm.

According to an embodiment, the shielding member 450 may be coupled to the second surface 411b of the substrate 410 and may provide a shielding function so that external electromagnetic interference does not act on at least one electrical component (e.g., a communication circuit) mounted on the second surface 411b of the substrate 410.

According to an embodiment, the electronic device 101 may include a ground area 3113. According to the illustrated embodiments, a portion of the first support member 311 is illustrated as being provided as the ground area 3113, but at least a portion of a main circuit board (e.g., the first circuit board 341 of FIGS. 4 to 5) may be provided as a ground area.

According to an embodiment, a ground area 3113 may be formed as at least a portion of the vertical support portion 3112. When anodizing oxidation treatment is performed on the outer surface of the vertical support portion 3112 to provide non-conductive characteristics, the ground area 3113 may be provided as a portion (e.g., a conductive portion) where at least a portion of a metal film formed by anodizing treatment is removed from the vertical support portion 3112.

According to an embodiment, the ground area 3113 may provide a ground plane for the shielding member 450. The ground area 3113 may be provided as at least a portion of the vertical support portion 3112 of the first support member 311, but the disclosure is not limited thereto. The ground area 3113 may be electrically connected to the shielding member 450 through the contacting portion 440, the bracket 430, and the first adhesive member 490.

According to an embodiment, the contacting portion 440 may protrude rearward from the 2-1th support portion 4321 of the bracket 430. For example, the contacting portion 440 may at least partially protrude from the 2-1th support portion 4321 to contact at least a portion of the ground area 3113.

According to the illustrated embodiment, the contacting portion 440 may be provided in a clip shape bent at least once from the 2-1th support portion 4321, but the disclosure is not limited thereto. The contacting portion 440 may be at least partially elastically deformed when contacting the ground area 3113. For example, the illustrated reference numeral 440a may be an area that overlaps the ground area 3113 when the contacting portion 440 contacts the ground area 3113, and the contacting portion 440 may be elastically deformed toward the antenna module 401 by the overlapping area of reference numeral 440a.

According to an embodiment, the contacting portion 440 may be elastically deformed and at least partially compressed, and may press the ground area 3113 by elastic restoring force. Accordingly, even when external impact is applied to the electronic device 101, the connection state between the contacting portion 440 and the ground area 3113 may be maintained.

According to an embodiment, the shielding member 450 and/or the conductive support member 403 may be electrically connected to the second surface 411b of the substrate 410, or may be electrically connected to at least one side surface among the side surfaces of the substrate 410. The shielding member 450 and/or the conductive support member 403 may be electrically connected to a metal portion (or a conductive portion) of the substrate 410.

According to an embodiment, at least one antenna structure 391 may be disposed adjacent to the substrate 410 of the antenna module 401. The metal portion (or conductive portion) of the substrate 410 may form parasitic resonance (or parasitic components) that reduces frequency efficiency (or antenna gain) in a specific frequency band of the RF signal of at least one antenna structure 391.

According to an embodiment, the metal portion of the substrate 410 may be electrically connected to the ground area 3113 of the electronic device 101 through the shielding member 450, the conductive support member 403, and the contacting portion 440. Accordingly, the metal portion of the substrate 410 may be electrically connected to a ground plane provided from the ground area 3113, and generation of parasitic resonance from the metal portion of the substrate 410 may be limited or decreased. Accordingly, antenna radiation efficiency of at least one antenna structure 391 may be enhanced.

Referring to FIGS. 14 to 15, a third side wall 3103 may include a bezel area 31031, 31032 forming at least a portion of the side structure 310. The bezel area 31031, 31032 may be formed of a metal material. The bezel area 31031, 31032 may include a first bezel area 31031 and a second bezel area 31032. The first bezel area 31031 may be connected to at least one antenna structure 391, a non-metal area 393, and a display 330. The second bezel area 31032 may be connected to at least one antenna structure 391, a non-metal area 393, and a rear plate 380.

Referring to FIG. 14, the antenna module 401 and/or the conductive support member 403 may be positioned between a display 330 (e.g., the display 330 of FIGS. 4 to 5) and a rear plate 380 (e.g., the rear plate 380 of FIGS. 4 to 5). The antenna module 401 and/or the conductive support member 403 may be seated on a seating portion 3111a. The seating portion 3111a may be positioned between the first support portion 431 and the rear plate 380. For example, the antenna module 401 and/or the conductive support member 403 may be moved downward while aligned above (e.g., in the +Z direction of FIG. 14) the seating portion 3111a and seated on the seating portion 3111a.

Referring to FIG. 15, the antenna module 401 and/or the conductive support member 403 may be positioned between a display 330 (e.g., the display 330 of FIGS. 4 to 5) and a rear plate 380 (e.g., the rear plate 380 of FIGS. 4 to 5). The antenna module 401 and/or the conductive support member 403 may be seated on a seating portion 3111b (e.g., the seating portion 3111a of FIGS. 13 to 13, or the seating portion 3111b of FIG. 15). The seating portion 3111b may be positioned between the first support portion 431 and the display 330. For example, the antenna module 401 and/or the conductive support member 403 may be moved upward while aligned below (e.g., in the -Z direction of FIG. 15) the seating portion 3111b and seated on the seating portion 3111b.

FIG. 16A is a plan view illustrating a 2-1th support portion of a conductive support member according to an embodiment of the disclosure.

FIG. 16B is a cross-sectional view taken along line C-C' of FIG. 16A according to an embodiment of the disclosure.

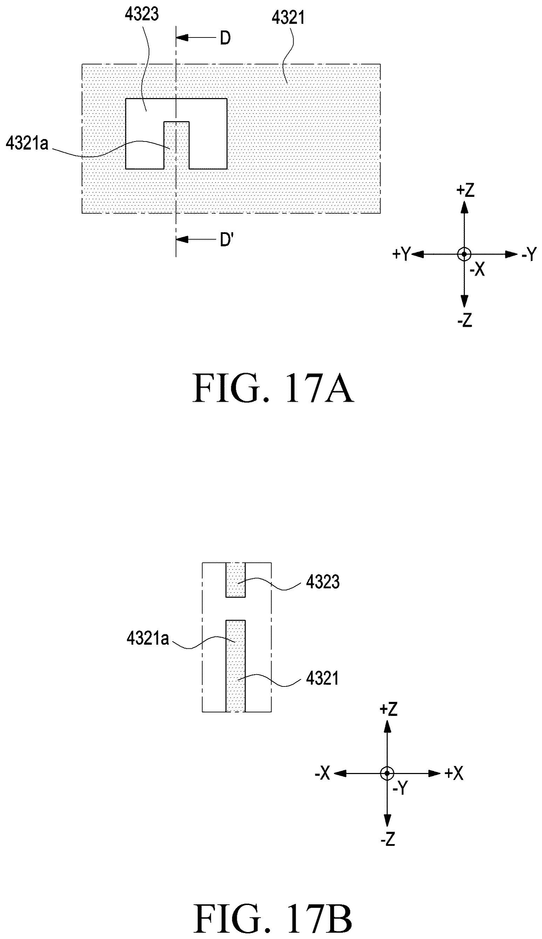

FIG. 17A is a plan view illustrating a 2-1th support portion of a conductive support member according to an embodiment of the disclosure.

FIG. 17B is a cross-sectional view taken along line D-D' of FIG. 17A according to an embodiment of the disclosure.

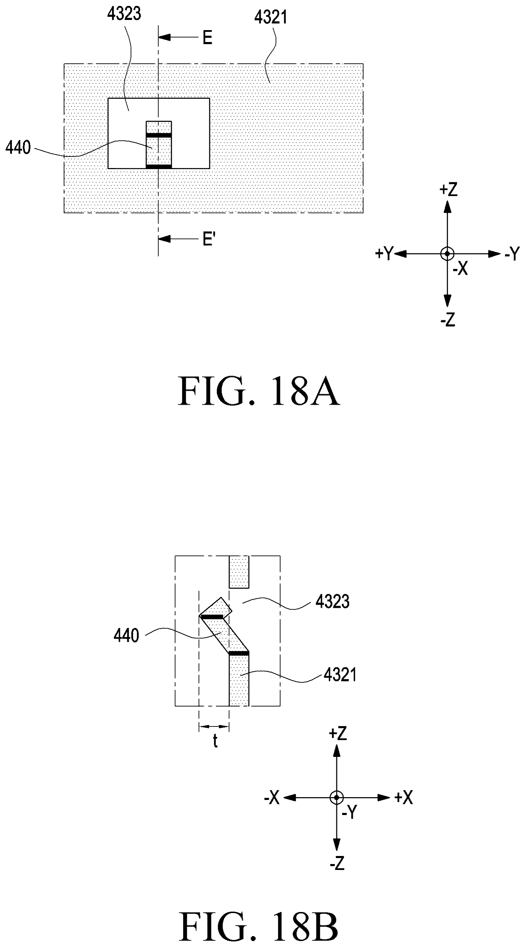

FIG. 18A is a plan view illustrating a 2-1th support portion and a contacting portion of a support member according to an embodiment of the disclosure.

FIG. 18B is a cross-sectional view taken along line E-E' of FIG. 18A according to an embodiment of the disclosure.

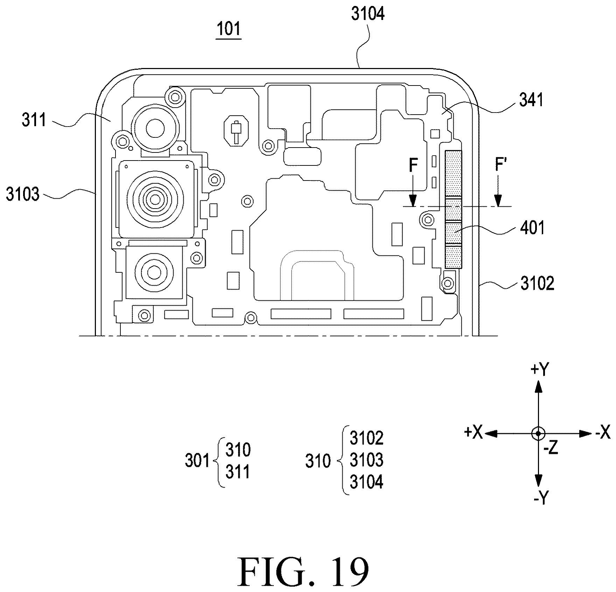

The embodiments of FIGS. 16A to 18B may be combined with the embodiments of FIGS. 1 to 15, or the embodiments of FIGS. 19 to 27.

The configuration of the 2-1th support portion 4321 or the contacting portion 440 of FIGS. 16A to 18B may be identical in whole or part to the configuration of the 2-1th support portion 4321 or the contacting portion 440 of FIGS. 6 to 15.

Hereinafter, the manufacturing process of the contacting portion 440 is described with reference to FIGS. 16A to 18B as an example. A bracket (e.g., the bracket 430 of FIGS. 6 to 15) may include a 2-1th support portion 4321. The 2-1th support portion 4321 may be formed as a metal plate. Referring to FIGS. 16A to 17B, the manufacturing process may include a process of forming a through portion 4323 in the 2-1th support portion 4321. The through portion 4323 may include an opening formed through at least a portion of the 2-1th support portion 4321. The opening may have a shape surrounding at least a portion 4321a of the 2-1th support portion 4321 for forming the contacting portion 440. Referring to FIGS. 17A to 18B, the manufacturing process may include a process of bending at least a portion 4321a of the 2-1th support portion 4321 at least once. At least a portion 4321a of the 2-1th support portion 4321 may be bent at least once to form a contacting portion 440. The contacting portion 440 may be formed by processing at least a portion of the 2-1th support portion 4321. The contacting portion 440 may be disposed to protrude from one surface (e.g., a surface facing the -X direction in FIG. 18B) of the 2-1th support portion 4321. For example, a distance that the contacting portion 440 protrudes from one surface of the 2-1th support portion 4321 may be defined and/or referred to as a second distance t. The second distance t may be a distance in a perpendicular direction (e.g., the X-axis direction in FIG. 18B) to one surface of the 2-1th support portion 4321. The second distance t may be greater than a first distance (e.g., the first distance g of FIG. 13) between the first surface of the substrate and the non-metal area. The second distance t may be about 0.9 mm to about 0.165 mm. For example, the second distance t may be about 0.1 mm to about 0.15 mm. The contacting portion 440 may be at least partially elastically deformed when the 2-1th support portion 4321 is closely contacted with the vertical support portion 3112 of the first support member 311.

FIG. 19 is a rear view illustrating an electronic device including an antenna module according to an embodiment of the disclosure.

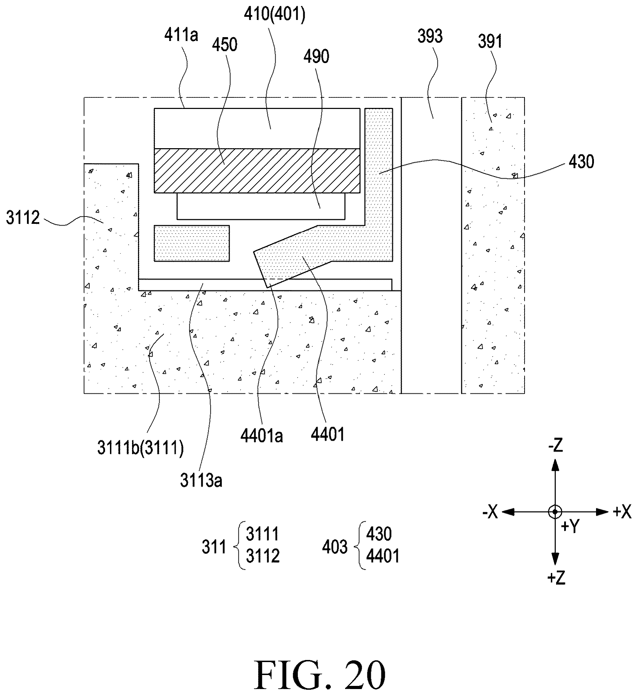

FIG. 20 is a cross-sectional view illustrating an electronic device taken along line F-F' of FIG. 19 according to an embodiment of the disclosure.

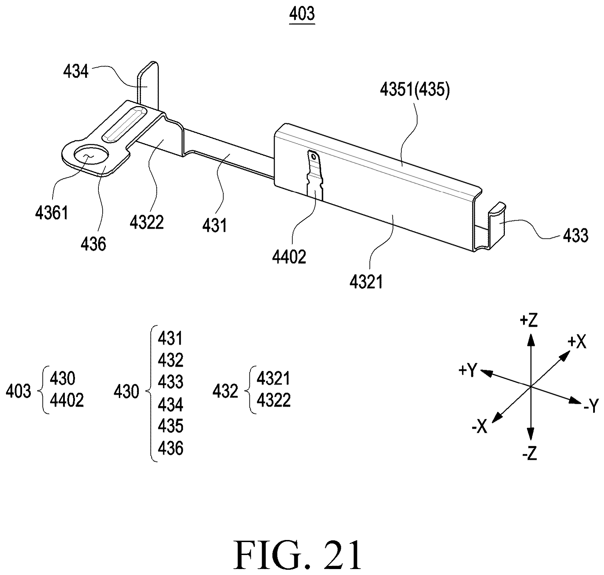

The embodiments of FIGS. 19 to 20 may be combined with the embodiments of FIGS. 1 to 18B, or the embodiments of FIGS. 21 to 27.

Referring to FIGS. 19 to 20, an electronic device 101 may include a housing 301, a side structure 310, a first support member 311, a second side wall 3102, a third side wall 3103, a fourth side wall 3104, a first circuit board 341, an antenna module 401, a substrate 410, a conductive support member 403, a bracket 430, a contacting portion 4401, a shielding member 450, a first adhesive member 490, at least one antenna structure 391, or a non-metal area 393. The first support member 311 may include a planar support portion 3111, or a vertical support portion 3112.

The configuration of the housing 301, the side structure 310, the first support member 311, the second side wall 3102, the third side wall 3103, or the fourth side wall 3104 of FIGS. 19 to 20 may be identical in whole or part to the configuration of the housing 301, the side structure 310, the first support member 311, the second side wall 3102, the third side wall 3103, or the fourth side wall 3104 of FIGS. 4 to 6. The configuration of the first circuit board 341 of FIGS. 19 to 20 may be identical in whole or part to the configuration of the first circuit board 341 of FIG. 4. The configuration of the antenna module 401, the substrate 410, the conductive support member 403, the bracket 430, the contacting portion 4401, the shielding member 450, the first adhesive member 490, at least one antenna structure 391, or the non-metal area 393 of FIGS. 19 to 20 may be identical in whole or part to the configuration of the antenna module 401, the substrate 410, the conductive support member 403, the bracket 430, the contacting portion 440, the shielding member 450, the first adhesive member 490, at least one antenna structure 391, or the non-metal area 393 of FIGS. 6 to 15. The configuration of the planar support portion 3111, or the vertical support portion 3112 of FIGS. 19 to 20 may be identical in whole or part to the configuration of the planar support portion 3111, or the vertical support portion 3112 of FIGS. 13 to 15.

According to an embodiment, the conductive support member 403 may include a bracket 430, or a contacting portion 4401.

According to an embodiment, the first surface 411a of the substrate 410 of the antenna module 401 may be disposed to face a rear plate (e.g., the rear plate 380 of FIGS. 4 to 5) of the electronic device 101. An antenna array (e.g., the antenna array 414 of FIGS. 10 to 11) disposed on the first surface may be disposed to face the rear plate of the electronic device 101. For example, the antenna array of the antenna module 401 may form a beam facing the rear direction of the electronic device 101.

According to an embodiment, the conductive support member 403 may include the contacting portion 440. The contacting portion 440 may be electrically connected to a ground area 3113a (e.g., the ground area 3113 of FIGS. 13 to 15) formed on a seating portion 3111a (e.g., the seating portion 3111a of FIGS. 13 to 14, or the seating portion 3111b of FIG. 15) of the first support member 311. The contacting portion 440 and the conductive support member 403 may provide a conductive path between the ground area 3113a and the shielding member 450.

The illustrated reference numeral 4401a may be an area that overlaps the ground area 3113a when the contacting portion 4401 contacts the ground area 3113a, and the contacting portion 4401 may be elastically deformed toward the antenna module 401 by the overlapping area of reference numeral 4401a.

FIG. 21 is a perspective view illustrating a conductive support member according to an embodiment of the disclosure.

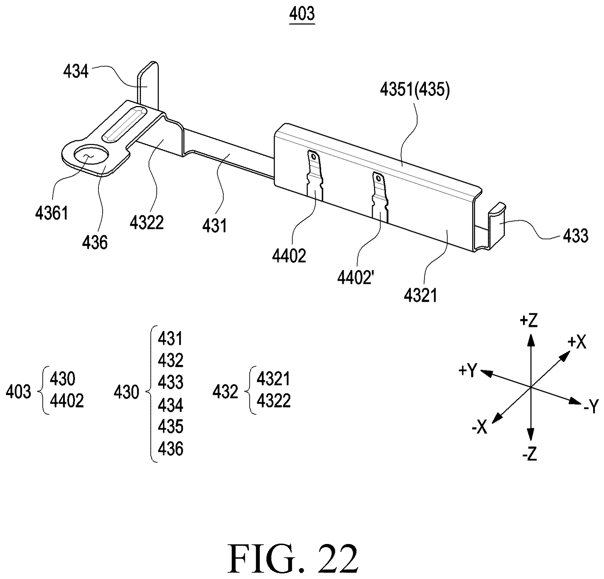

FIG. 22 is a perspective view illustrating a conductive support member according to an embodiment of the disclosure.

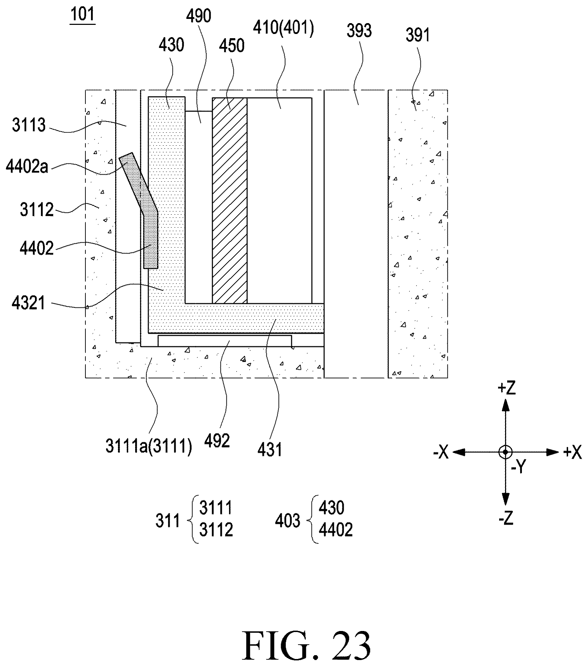

FIG. 23 is a cross-sectional view illustrating an electronic device according to an embodiment of the disclosure.

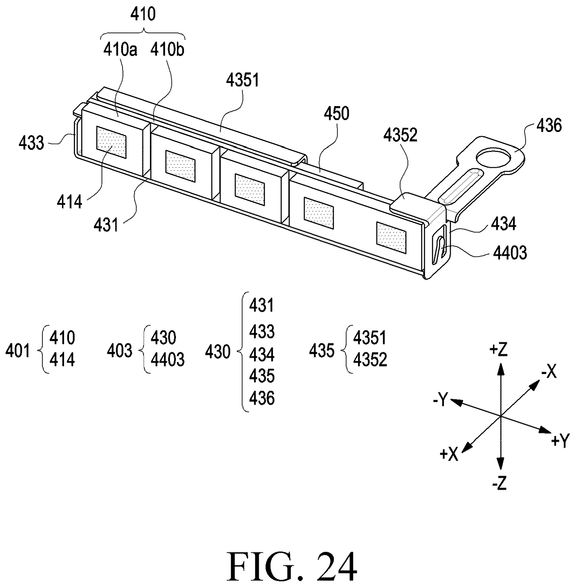

The embodiments of FIGS. 21 and 23 may be combined with the embodiments of FIGS. 1 to 20 or the embodiments of FIGS. 24 to 27.

Referring to FIGS. 21 to 23, an electronic device 101 may include a first support member 311, an antenna module 401, a substrate 410, a conductive support member 403, a bracket 430, a contacting portion 4402, a shielding member 450, a first adhesive member 490, at least one antenna structure 391, or a non-metal area 393. The bracket 430 may include a first support portion 431, a second support portion 432, a 2-1th support portion 4321, a 2-2th support portion 4322, a third support portion 433, a fourth support portion 434, a fifth support portion 435, a 5-1th support portion 4351, a 5-2th support portion 4352, or a connection portion 436. The first support member 311 may include a planar support portion 3111, or a vertical support portion 3112.

The configuration of the first support member 311, the antenna module 401, the substrate 410, the conductive support member 403, the bracket 430, the contacting portion 4402, the shielding member 450, the first adhesive member 490, at least one antenna structure 391, or the non-metal area 393 of FIGS. 21 to 23 may be identical in whole or part to the configuration of the antenna module 401, the substrate 410, the conductive support member 403, the bracket 430, the contacting portion 440, the shielding member 450, the first adhesive member 490, the second adhesive member 492, at least one antenna structure 391, or the non-metal area 393 of FIGS. 6 to 15. The configuration of the planar support portion 3111, or the vertical support portion 3112 of FIGS. 21 to 23 may be identical in whole or part to the configuration of the planar support portion 3111, or the vertical support portion 3112 of FIGS. 13 to 15.

According to an embodiment, the contacting portion 4402 may be manufactured as a separate member from the bracket 430 and assembled to the bracket 430. The contacting portion 4402 may be formed of a metal material and may be welded or screw-coupled to at least a portion of the bracket 430. The contacting portion 4402 may be coupled to the 2-1th support portion 4321 of the bracket 430, but the disclosure is not limited thereto. The contacting portion 4402 may be attached to at least a portion (e.g., the 2-1th support portion 4321) of the bracket 430.

According to an embodiment, the contacting portion 4402 may be manufactured from the same material as or a different material from the bracket 430 and attached to the bracket 430. For example, the contacting portion 4403 may include a conductive gasket. For example, the contacting portion 4402 may include a conductive foam gasket, and an outer shell of the conductive foam gasket may include a conductive fiber, a metal foil and/or a metal thin film. For example, the contacting portion 4402 may be attached to the bracket 430 using a conductive double-sided tape. According to an embodiment, the contacting portion 4402 may include a flexible printed circuit board (FPCB) or a coaxial cable.

According to an embodiment, the contacting portion 4402 may be provided as one contacting portion 4402 as illustrated in FIG. 21, or may be provided as a plurality of contacting portions 4402, 4402' as illustrated in FIG. 22.

According to an embodiment, the contacting portion 4402 may be electrically connected to the ground area 3113 (e.g., the ground area 3113 of FIGS. 13 to 15) formed on the vertical support portion 3112 of the first support member 311. The contacting portion 4402 and the conductive support member 403 may provide a conductive path between the ground area 3113 and the shielding member 450.

The illustrated reference numeral 4402a may be an area that overlaps the ground area 3113 when the contacting portion 4402 contacts the ground area 3113, and the contacting portion 4402 may be elastically deformed toward the antenna module 401 by the overlapping area of reference numeral 4401a.

FIG. 24 is a perspective view illustrating an antenna module and a conductive support member according to an embodiment of the disclosure.

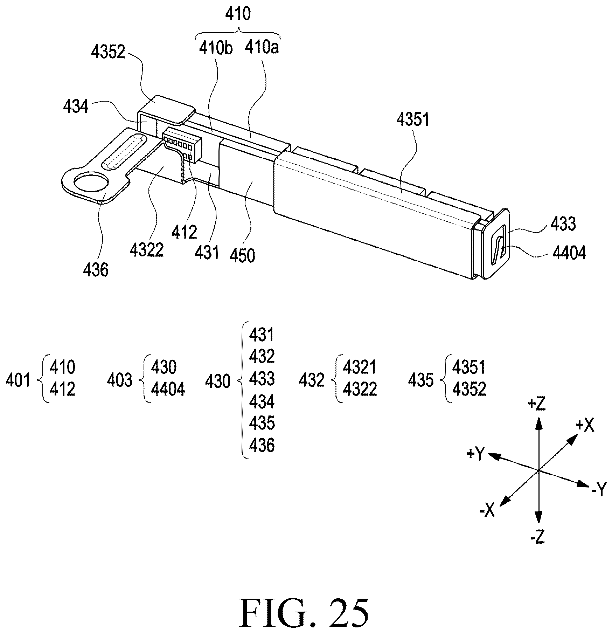

FIG. 25 is a perspective view illustrating an antenna module and a conductive support member according to an embodiment of the disclosure.

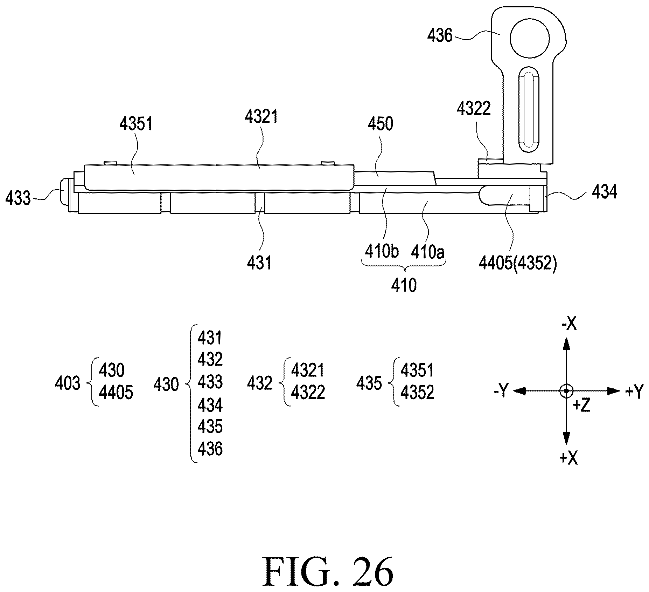

FIG. 26 is a perspective view illustrating an antenna module and a conductive support member according to an embodiment of the disclosure.

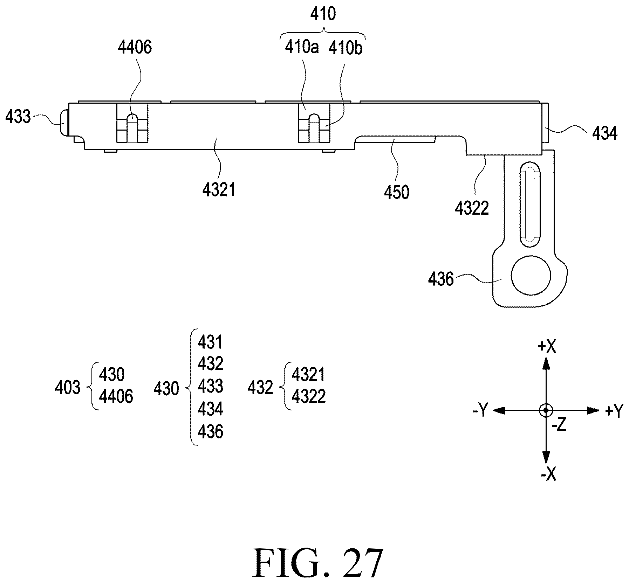

FIG. 27 is a perspective view illustrating an antenna module and a conductive support member according to an embodiment of the disclosure.

The embodiments of FIGS. 24 to 27 may be combined with the embodiments of FIGS. 1 to 23.

Referring to FIGS. 24 to 27, an electronic device 101 may include an antenna module 401, a substrate 410, a first substrate 410a, a second substrate 410b, a first connector 412, an antenna array 414, a conductive support member 403, a first support portion 431, a second support portion 432, a 2-1th support portion 4321, a 2-2th support portion 4322, a third support portion 433, a fourth support portion 434, a fifth support portion 435, a 5-1th support portion 4351, a 5-2th support portion 4352, a connection portion 436, a contacting portion 4403, 4404, 4405, 4406, or a shielding member 450.

The configuration of the antenna module 401, the substrate 410, the first substrate 410a, the second substrate 410b, the first connector 412, the antenna array 414, the conductive support member 403, the first support portion 431, the second support portion 432, the 2-1th support portion 4321, the 2-2th support portion 4322, the third support portion 433, the fourth support portion 434, the fifth support portion 435, the 5-1th support portion 4351, the 5-2th support portion 4352, the connection portion 436, the contacting portion 4403, 4404, 4405, 4406, or the shielding member 450 of FIGS. 24 to 27 may be identical in whole or part to the configuration of the antenna module 401, the substrate 410, the first substrate 410a, the second substrate 410b, the first connector 412, the antenna array 414, the conductive support member 403, the first support portion 431, the second support portion 432, the 2-1th support portion 4321, the 2-2th support portion 4322, the third support portion 433, the fourth support portion 434, the fifth support portion 435, the 5-1th support portion 4351, the 5-2th support portion 4352, the connection portion 436, the contacting portion 440, or the shielding member 450 of FIGS. 6 to 12.

Referring to FIG. 24, the contacting portion 4403 may be formed on the fourth support portion 434 that covers a left-facing side surface among the side surfaces of the antenna module 401. The contacting portion 4403 may be integrally formed with the fourth support portion 434, or may be formed as a separate member from the fourth support portion 434 and assembled to the fourth support portion 434. The contacting portion 4403 may be electrically connected to a ground area (e.g., the ground area 3113 of FIGS. 13 to 15) of the electronic device 101. The contacting portion 4403 may provide a conductive path between the ground area and the shielding member 450.

Referring to FIG. 25, the contacting portion 4404 may be formed on the third support portion 433 that covers a right-facing side surface among the side surfaces of the antenna module 401. The contacting portion 4404 may be integrally formed with the third support portion 433, or may be formed as a separate member from the third support portion 433 and assembled to the third support portion 433. The contacting portion 4404 may be electrically connected to a ground area (e.g., the ground area 3113 of FIGS. 13 to 15) of the electronic device 101. The contacting portion 4404 may provide a conductive path between the ground area and the shielding member 450.

Referring to FIG. 26, the contacting portion 4405 may be formed on the fifth support portion 435 that covers an upward-facing side surface among the side surfaces of the antenna module 401. The contacting portion 4405 may be formed on at least a portion of the 5-2th support portion 4352. The contacting portion 4405 may be integrally formed with the 5-2th support portion 4352, or may be formed as a separate member from the 5-2th support portion 4352 and assembled to the 5-2th support portion 4352. The contacting portion 4405 may be electrically connected to a ground area (e.g., the ground area 3113 of FIGS. 13 to 15) of the electronic device 101. The contacting portion 440 may provide a conductive path between the ground area and the shielding member 450.

Referring to FIG. 27, the contacting portion 4406 may be formed on the first support portion 431 that covers a downward-facing side surface among the side surfaces of the antenna module 401. The contacting portion 4406 may be integrally formed with the first support portion 431, or may be formed as a separate member from the first support portion 431 and assembled to the first support portion 431. The contacting portion 4406 may be electrically connected to a ground area (e.g., the ground area 3113 of FIGS. 13 to 15) of the electronic device 101. The contacting portion 440 may provide a conductive path between the ground area and the shielding member 450.

An electronic device may include at least one antenna radiator to transmit and/or receive radio frequency (RF) signals of various frequency bands. As an example, an electronic device may include an antenna formed as part of a metal frame forming the exterior of the electronic device, or an antenna disposed in an inner space of the electronic device.

According to the trend of miniaturization and/or thinning of electronic devices, space for mounting or receiving the antennas and at least one electrical/electronic component is gradually decreasing. Accordingly, the antennas and at least one electrical/electronic component are designed to be positioned adjacent to each other, and accordingly, electromagnetic waves generated from each may act as noise to surrounding antennas or surrounding components. Further, as antennas supporting wireless communication of different frequency bands are positioned adjacent to each other, when one antenna operates, parasitic resonance may occur in another antenna, which may reduce antenna radiation efficiency (or antenna gain).

According to an embodiment of the disclosure, by including a conductive support member, an electronic device having a stable operating environment may be provided.

According to an embodiment of the disclosure, by connecting a conductive support member to a ground area of an electronic device, generation of parasitic resonance in a substrate of an antenna module may be limited or decreased.

However, the objects of the disclosure are not limited to those mentioned above, and may be variously determined within a range that does not depart from the spirit and scope of the disclosure.

According to an embodiment of the disclosure, by coupling a conductive support member inside a housing in an interference fit manner, the maintaining force of the connection state between a contacting portion of the conductive support member and a ground area may be enhanced.

The effects obtainable from the disclosure are not limited to the effects mentioned above, and other effects not mentioned may be clearly understood by those skilled in the art to which the disclosure belongs from the following description.

According to an embodiment of the disclosure, an electronic device 101 may include a housing 301, 311, a circuit board 341, an antenna module 401, or a conductive support member 403. The housing may include a ground area 3113. The circuit board may be disposed inside the housing. The antenna module may be disposed in the housing. The antenna module may be disposed in the housing. The antenna module may be electrically connected to the circuit board. The antenna module may include a substrate 410, or an antenna array 414. The antenna array may be disposed on the substrate. The conductive support member may be configured to support the antenna module. The conductive support member may include a bracket 430, or a contacting portion 440. The bracket may surround at least a portion of the substrate. The contacting portion may protrude from the bracket. The contacting portion may contact the ground area. The contacting portion may be electrically connected to the ground area.

According to an embodiment, the contacting portion may be configured to be at least partially elastically deformable.

According to an embodiment, the antenna array may include a plurality of antenna elements 414A, 414B, 414C, 414D, 414E. The plurality of antenna elements may be disposed on a first surface 411a of the substrate. The bracket may surround at least one surface of the substrate facing a direction different from the direction that the first surface of the substrate faces.

According to an embodiment, the electronic device may further include a shielding member 450. The shielding member may be disposed on a second surface 411b of the substrate. The shielding member may be electrically connected to the bracket.

According to an embodiment, the second surface may face a direction opposite to the first surface. The shielding member may be electrically connected to the second surface.

According to an embodiment, the bracket and the contacting portion may be integrally formed.

According to an embodiment, the contacting portion may be formed by bending at least a portion of the bracket.

According to an embodiment, the contacting portion 4402 may be attached to at least a portion of the bracket.

According to an embodiment, the electronic device may further include a conductive connecting member 470. The conductive connecting member may be electrically connected to the circuit board, or the antenna module.

According to an embodiment, the conductive connecting member may include at least one of a flexible printed circuit board or a coaxial cable.

According to an embodiment, the substrate may include a first surface 411a, or a second surface 411b. The antenna array may be disposed on the first surface. The second surface may face a direction opposite to the first surface. The bracket may include a first support portion 431, or a second support portion 432. The first support portion may be configured to support one of a plurality of side surfaces of the substrate connected to the first surface and the second surface. The second support portion may extend from the first support portion. The second support portion may be configured to support the second surface.

According to an embodiment, the contacting portion may be positioned at the second support portion.

According to an embodiment, the electronic device may further include at least one antenna structure 391. The antenna module may face the at least one antenna structure.

According to an embodiment, the housing may further include a non-metal area 393. The non-metal area may be disposed between the at least one antenna structure and the antenna module.

According to an embodiment, the substrate, or the antenna array may be spaced apart from the non-metal area.

According to an embodiment of the disclosure, an electronic device 101 may include a housing 301, 311, a circuit board 341, an antenna module 401, a conductive support member 403, or a shielding member 450. The housing may include a ground area 3113. The circuit board may be disposed inside the housing. The antenna module may be disposed in the housing. The antenna module may be disposed in the housing. The antenna module may be electrically connected to the circuit board. The antenna module may include a substrate 410, or an antenna array 414. The antenna array may be disposed on the substrate. The conductive support member may be configured to support the antenna module. The conductive support member may include a bracket 430, or a contacting portion 440. The bracket may surround at least a portion of the substrate. The contacting portion may protrude from the bracket. The contacting portion may contact the ground area. The contacting portion may be electrically connected to the ground area. The shielding member may be disposed between the bracket and the substrate. The shielding member may be electrically connected to the bracket, or the substrate.

According to an embodiment, the electronic device may further include a conductive adhesive member 490. The conductive adhesive member may be positioned between the shielding member and the bracket.

According to an embodiment, the antenna array may be disposed on a first surface 411a of the substrate. The bracket may include a plurality of support portions 431, 432, 433, 434, 435. The plurality of support portions may be configured to support a plurality of side surfaces of the substrate facing directions different from the direction that the first surface faces.

According to an embodiment, the contacting portion 440, 4401, 4402, 4403, 4404, 4405, 4406 may be formed on one of the plurality of support portions.

According to an embodiment, the contacting portion and the bracket may be configured to provide a conductive path electrically connecting the ground area and the shielding member.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device (101) comprising:
a housing (301, 311) including a ground area (3113);
a circuit board (341) disposed in the housing;
an antenna module (401) disposed in the housing, electrically connected to the circuit board and including a substrate (410) and an antenna array (414) disposed on the substrate; and
a conductive support member (403) configured to support the antenna module,
wherein the conductive support member includes:
a bracket (430) surrounding at least a portion of the substrate; and
a contacting portion (440) protruding from the bracket, contacting the ground area and electrically connected to the ground area.

2. The electronic device of claim 1, wherein the contacting portion is configured to be at least partially elastically deformable.

3. The electronic device of claim 1 or 2, wherein the antenna array includes a plurality of antenna elements (414A, 414B, 414C, 414D, 414E) disposed on a first surface (411a) of the substrate, and
wherein the bracket surrounds at least one surface of the substrate facing in a direction different from a direction in which the first surface of the substrate faces.

4. The electronic device of any one of claims 1 to 3, further comprising a shielding member (450) disposed on a second surface (411b) of the substrate and electrically connected to the bracket.

5. The electronic device of any one of claims 1 to 4, wherein the second surface faces in a direction opposite to the first surface, and
wherein the shielding member is electrically connected to the second surface.

6. The electronic device of any one of claims 1 to 5, wherein the bracket and the contacting portion are integrally formed.

7. The electronic device of any one of claims 1 to 6, wherein the contacting portion is formed by bending at least part of the bracket.

8. The electronic device of any one of claims 1 to 5, wherein the contacting portion (4402) is attached to at least part of the bracket.

9. The electronic device of any one of claims 1 to 8, further comprising a conductive connection member (470) electrically connected to the circuit board and the antenna module.

10. The electronic device of any one of claims 1 to 9, wherein the conductive connection member includes at least one of a flexible printed circuit board or a coaxial cable.

11. The electronic device of any one of claims 1 to 10, wherein the substrate includes:
a first surface (411a) on which the antenna array is disposed; and
a second surface (411b) facing in a direction opposite to the first surface,
wherein the bracket includes:
a first support portion (431) configured to support one among a plurality of side surfaces of the substrate connected to the first surface and the second surface; and
a second support portion (432) extending from the first support portion and configured to support the second surface.

12. The electronic device of any one of claims 1 to 11, wherein the contacting portion is located at the second support portion.

13. The electronic device of any one of claims 1 to 12, further comprising at least one antenna structure (391), and
wherein the antenna module faces the at least one antenna structure.

14. The electronic device of any one of claims 1 to 13, wherein the housing further includes a non-metal area (393) disposed between the at least one antenna structure and the antenna module.

15. The electronic device of any one of claims 1 to 14, wherein the substrate and the antenna array are spaced apart from the non-metal area.
